# EUROPÄISCHE PATENTANMELDUNG

(11) **EP 4 236 132 A2**
(43) Veröffentlichungstag der Anmeldung: **30.08.2023**
(21) Anmeldenummer: 23180790.0
(22) Anmeldetag: 21.06.2023
(51) Int. Cl.: H04L 1/00, H04L 25/49

(54) **EFFIZIENT ÜBERTRAGBARE BITFOLGE MIT EINGESCHRÄNKTER DISPARITÄT UND LEITUNGSKODIERTER VORWÄRTSFEHLERKORREKTUR**

(71) Anmelder: Inova Semiconductors, 81671 München (DE)
(72) Erfinder: Kluge, Fabian, Perasdorf (DE); Neumann, Roland, Bad Tölz (DE)
(74) Vertreter: Reich, Jochen

(57) **Zusammenfassung**

Die vorliegende Erfindung ist auf ein Verfahren zum Erzeugen einer effizient übertragbaren Bitfolge mit einer eingeschränkten Disparität und einer eingeschränkten Lauflänge gerichtet. Das vorgeschlagene Verfahren erlaubt es, dass Daten über einen Übertragungskanal besonders effizient übertragen werden können. Die Erfindung schafft gegenüber dem Stand der Technik unter anderem den Vorteil, dass trotz einer Reduzierung des Ressourcenbedarfs das physikalische Verhalten auf einem Übertragungskanal stets deterministisch kontrollierbar ist. So sind gemäß dem vorgeschlagenen Verfahren die Bitfehler minimal und ein Übertragungsfehler kann effizient, d.h. mit minimalem technischem Aufwand, korrigiert werden. Darüber hinaus sind die verwendeten Kodierer bezüglich ihrer Anzahl der Gatter minimal ausgestaltet und es ist dem vorgeschlagenen Verfahren eine Verschachtelung implizit, die darauf abstellt, dass sogenannte Burst Fehler besonders vorteilhaft korrigiert werden können.

## Beschreibung

Die vorliegende Erfindung ist auf ein Verfahren zum Erzeugen einer effizient übertragbaren Bitfolge mit einer eingeschränkten Disparität und einer eingeschränkten Lauflänge gerichtet. Das vorgeschlagene Verfahren erlaubt es, dass Daten über einen Übertragungskanal besonders effizient übertragen werden können. Die Erfindung schafft gegenüber dem Stand der Technik unter anderem den Vorteil, dass trotz einer Reduzierung des Ressourcenbedarfs das physikalische Verhalten auf einem Übertragungskanal stets deterministisch kontrollierbar ist. So sind gemäß dem vorgeschlagenen Verfahren die Bitfehler minimal und ein Übertragungsfehler kann effizient, d.h. mit minimalem technischem Aufwand, korrigiert werden. Darüber hinaus sind die verwendeten Kodierer bezüglich ihrer Anzahl der Gatter minimal ausgestaltet und es ist dem vorgeschlagenen Verfahren eine Verschachtelung implizit, die darauf abstellt, dass sogenannte Burst Fehler besonders vorteilhaft korrigiert werden können. Diese implizite Verschachtelung ermöglicht es, dass die benötigten herkömmlichen Pufferspeicher einer expliziten Verschachtelung entfallen können. Darüber hinaus wird erfindungsgemäß sichergestellt, dass Nutzdaten mitsamt korrigierender Metadaten vorteilhaft bezüglich der Übertragung kodiert werden können. Erfindungsgemäß kann sichergestellt werden, dass nicht nur die Nutzdaten linienkodiert bzw. leitungskodiert werden, sondern eben auch die Korrekturdaten. Eine optimierte Disparität stellt ein Qualitätsmerkmal für die Übertragbarkeit von Daten dar. Eine nachteilige Disparität kann dazu führen, dass Daten über einen Datenkanal nicht ordnungsgemäß übertragen werden können, da diese vom Empfänger nicht ordnungsgemäß interpretiert werden können. Ein weiteres Qualitätsmerkmal ist die Dateneffizienz bezüglich des Verhältnisses von übertragenen Nutzdaten und einer weiteren Datenmenge, welche sich nicht direkt auf die Nutzdaten inhaltlich bezieht. Hierzu gehören sogenannte Kopfdaten. Die vorgeschlagene Erfindung erlaubt es, Datenströme zu erzeugen, welche besonders effizient ausgelesen werden können und zudem auch bezüglich der Überhangdaten sehr effizient sind. So wird der sogenannte Overhead der Nutzdaten minimiert, was wiederum ein besonders effizientes Verfahren schafft. Auch die empfängerseitige eindeutige Interpretierbarkeit sorgt dafür, dass Daten nicht wiederholt übertragen werden müssen, sondern vielmehr können diese mit hoher Fehlersicherheit empfängerseitig ausgelesen werden. Darüber hinaus ist das vorgeschlagene Verfahren besonders effizient, da eine Überführung von Datensegmenten in Teilsymbole beziehungsweise in Symbole die aus Teilsymbolen aufgebaut sind, parallel ausgeführt werden kann und zudem sind bei dieser parallelen Ausführung lediglich technisch einfach herzustellende Einheiten notwendig. Somit bezieht sich vorliegend der Effizienzgewinn auch auf die zu verwendende Hardware bzw. Laufzeit. Die Erfindung ist ferner gerichtet auf eine entsprechend eingerichtete Systemanordnung sowie auf ein Computerprogrammprodukt und ein speicherlesbares Medium mit Steuerbefehlen, welche das Verfahren ausführen.

EP 3323219 A1 zeigt ein Verfahren, welches es ermöglicht einen analogen Datenstrom über eine Datenleitung besonders fehlersicher auszulesen. Hierbei wird unter anderem die Amplitude des Signals überwacht und besonders bevorzugt an derjenigen Stelle das Signal gemessen, an der die Amplitude maximal ist. Hierdurch wird ein analoger Datenstrom in einen digitalen Datensatz überführt und durch die maximale Amplitude wird sichergestellt, dass der Schwellwert zwischen 0 und 1 auf der Leitung sicher unter- bzw. überschritten wird.

Aus dem Stand der Technik sind unterschiedliche Kodierungsverfahren bzw. Datenübertragungsverfahren bekannt, welche sich jedoch allesamt auf Anwendungsszenarien beziehen, welche in einem Automobil nur nachteilig Einsatz finden können. So geht der Stand der Technik oftmals davon aus, dass eine hohe Rechenleistung verfügbar ist und keine hohen Echtzeitanforderungen gestellt werden. Darüber hinaus geht der Stand der Technik oftmals davon aus, dass ein Gewicht bzw. eine Ausfallsicherheit der zu verwendenden Komponenten eine untergeordnete Rolle spielt. Oftmals bezieht sich der Stand der Technik auf herkömmliche Computernetzwerke, bei denen die Ausfallsicherheit bzw. ein geringer technischer Aufwand weniger von Bedeutung sind.

Ferner ist aus dem Stand der Technik die sogenannte Vorwärtsfehlerkorrektur bekannt. Forward Error Correction (FEC) ist eine Methode zur Fehlerkorrektur, bei der zusätzliche Redundanzinformationen zu den Daten hinzugefügt werden. Diese Redundanz ermöglicht es dem Empfänger, Fehler zu erkennen und zu korrigieren, ohne dass das Paket erneut gesendet werden muss. FEC wird oft in Hochgeschwindigkeits-Ethernet-Verbindungen wie 10 Gigabit Ethernet (10GbE) eingesetzt, um die Datenintegrität sicherzustellen.

Ausgehend von diesem Stand der Technik besteht ein Bedarf ein Verfahren bzw. eine Systemanordnung zu schaffen, welche es ermöglicht, dass aufgrund der Sicherheitsanforderungen im Automobil Daten möglichst schnell verarbeitet werden können und zudem ein geringer technischer Aufwand besteht und die Fehlerrate bei der Übertragung minimiert ist, da eine erneute Übertragung bei Fehlererkennung nicht möglich ist. Der geringe technische Aufwand soll darin bestehen, dass möglichst einfache Komponenten zu verbauen sind, welche wenig Gewicht aufweisen und zudem in großer Stückzahl effizient herstellbar sind. Bekannte Verfahren und Systemanordnungen aus der Computernetzwerktechnik sind hier typischerweise nicht verwendbar, da bei einem Stand-PC bzw. Server Gewichtseinsparungen und Echtzeitlaufverhalten nicht ausschlaggebend sind. Generell spielt zwar bei Rechneranordnungen die abzutransportierende Wärme eine Herausforderung dar, die Energieeffizienz in einem Automobil ist jedoch von nochmals übergeordneter Rolle, da beispielsweise in der Elektromobilität der Stromverbrauch sogar auf die Reichweite des Automobils Einfluss hat.

Weiterer Stand der Technik bezieht sich auf die Übertragung von Daten in einem seriellen Datenstrom. Hierzu sieht der Stand der Technik beispielsweise vor, dass mit den Nutzdaten umfangreiche Beschreibungsdaten mitgesendet werden, welche angeben, wo sich die Nutzdaten befinden bzw. wie die zu interpretieren sind. Darüber hinaus ist es im Stand der Technik bekannt, einzelne Datenpakete zu verwerfen, wenn diese nicht ordnungsgemäß übertragen werden. Darüber hinaus ist es im Stand der Technik bekannt Datenpakete erneut zu versenden, falls diese nicht rechtzeitig bzw. in einem unerwarteten Format bei einem Sender eintreffen.

Bei der seriellen Übertragung von Daten ist es notwendig die Anzahl von Einsen und Nullen im seriellen Datenstrom möglichst gleich zu haben. Dies nennt man die Disparität. Eine Disparität von Null im großen Mittel und aber auch über einen kleinen Zeitraum ist wünschenswert, damit es nicht zu einem sogenannten Baseline Drift bei der Übertragung kommt. Der Baseline Drift (Gleichspannungsschwankung) des seriellen Signals führt zu Bitfehlern. Im Extremfall ist eine Übertragung nicht möglich.

Um die seriellen Bits im seriellen Datenstrom, sicher auf der Empfangsseite zurückgewinnen zu können, ohne die Notwendigkeit einen Takt mit zu übertragen, ist eine Mindestanzahl von 0->1 beziehungsweise 1->0 Übergängen notwendig. Damit wird der Takt zur Rückgewinnung der seriellen Daten lokal am Empfänger aus dem seriellen Datenstrom erzeugt. Die sogenannte Lauflänge (Run Length) gibt an, wieviel gleiche Bits (Einsen oder Nullen) hintereinander, ohne Wechsel vorkommen können. Eine kleine Lauflänge ist immer wünschenswert, da große Lauflängen eine sichere Rückgewinnung des Taktes aus dem seriellen Datenstrom nicht mehr ermöglichen.

Die Aufgabe des Linecodes (in diesem Fall ein Block Code) ist es nun aus beliebigen Datenwörtern mit beliebiger Disparität und unendlicher Lauflänge ein Symbol mit garantierter Disparität und garantierter Lauflänge zu erzeugen. Dies führt zu einem Overhead bei der Übertragung. Es müssen also mehr Bits (in Form von Symbolen) übertragen werden als in dem netto zu übertragenden Daten Wort vorkommen. Das führt dazu, dass die benötigte Übertragungsgeschwindigkeit (Bandbreite) größer sein muss als die Datenrate der zu übertragenden Daten. Dies führt wiederum dazu, dass Systeme höhere Fehlerraten oder mehr Aufwand, Strom, etc. benötigen, als zur Übertragung der Rohdaten notwendig wäre.

Der Stand der Technik weist entweder einen hohen Overhead auf (8B10B) oder die Qualität des kodierten Signals hinsichtlich Disparität und Lauflänge ist sehr schlecht, so dass oft noch zusätzliche Maßnahmen (Komplexität) wie Scrambler notwendig werden, um die Qualität bei Disparität oder Lauflänge zu verbessern.

Demgemäß ist es eine Aufgabe der vorliegenden Erfindung ein Verfahren zu schaffen, welches eine besonders effizient übertragbare Bitfolge erzeugt die zudem sicher übertragen werden kann. Effizient kann sich hierbei auf die Hardwareeffizienz, die effiziente Entschlüsselung auf der Empfängerseite, die fehlende Notwendigkeit einer redundanten Datenübermittlung aufgrund nicht interpretierbarer Signale und/ oder auf das Verhältnis von Nutzdaten zu Überhangdaten beziehen. Darüber hinaus soll es erfindungsgemäß möglich sein, eine besonders effiziente Hardware zu schaffen bzw. zu verwenden, welche eine Laufzeitoptimierung durch eine parallele Verarbeitung ermöglicht. Ferner ist es eine Aufgabe eine entsprechend eingerichtete Systemanordnung bereitzustellen, sowie ein Computerprogrammprodukt und ein computerlesbares Speichermedium mit Steuerbefehlen, welche das Verfahren ausführen bzw. die Systemanordnung betreiben.

Die Aufgabe wird gelöst mit den Merkmalen des Patentanspruchs 1. Weitere vorteilhafte Ausgestaltungen sind in den Unteransprüchen angegeben.

Demgemäß wird ein Verfahren in einem Automobil zum Erzeugen einer effizient übertragbaren Bitfolge mit einer eingeschränkten Disparität, einer eingeschränkten Lauflänge und einer leitungskodierten Vorwärtsfehlerkorrektur vorgeschlagen, aufweisend ein Bereitstellen einer beliebigen Bitfolge; ein Segmentieren der bereitgestellten Bitfolge in eine vorab definierte Folge von Segmenten gemäß einer jeweils vorab definierten Bitlänge; ein Berechnen einer Vorwärtsfehlerkorrektur für jedes der Segmente oder eine Vielzahl von Segmenten derselben Bitlänge; ein Kodieren jedes Segments oder einer Vielzahl von Segmenten gleicher Bitposition mitsamt dessen/ deren Vorwärtsfehlerkorrektur in jeweils ein oder mehrere Teilsymbole, unter Verwendung jeweils derselben Kodiereinheit für die Segmente gleicher Bitposition und der zugehörigen Vorwärtsfehlerkorrektur aus einer Mehrzahl von Kodiereinheiten, wobei eine erste Teilmenge von Kodiereinheiten ein Vorzeichen der Disparität des Teilsymbols durch Invertieren der Disparität des erzeugten Teilsymbols zum Ausgleich einer Disparität einer zweiten Teilmenge von Kodiereinheiten aktiv steuert, wobei eine Aneinanderreihung der Teilsymbole die effizient übertragbare Bitfolge mitsamt den berechneten Vorwärtsfehlerkorrekturen ergibt.

In einem vorbereitendem Verfahrensschritt ist es möglich, einen potenziell unendlich andauernden Bitstrom bereitzustellen, welcher die beliebige Bitfolge aufweist. Der Datenstrom ist je nach Anwendungsszenario bereits beliebig lang ausgestaltet und kann wiederum in Worte beziehungsweise eine beliebige Bitfolge unterteilt werden. Somit wird ein Ausgangsdatenstrom bereitgestellt, welcher eine Bitfolge aufweist, die potentiell beliebig lang ist. Diese beliebige Länge kann aber in einem vorbereitendem Verfahrensschritt definiert werden und kann bevorzugt als 112 Bit definiert werden. Sobald die Länge beziehungsweise die Bitlänge der beliebigen Bitfolge definiert ist, ist diese gemäß einem Aspekt der vorliegenden Erfindung festgeschrieben. Insofern kann eine beliebige Länge der Bitfolge im Sinne der vorliegenden Erfindung nicht als willkürlich verstanden werden. Vielmehr kann als Synonym der beliebigen Bitfolge erfindungsgemäß eine Bitfolge vorgesehen sein, welche vorab in der Länge frei wählbar ist und/ oder deren Inhalt den zu übertragenden Daten entspricht oder zumindest eines Teils der zu übertragenden Daten.

In einem vorbereitendem Verfahrensschritt ist es folglich möglich, einen Ausgangsdatenstrom bereitzustellen, welcher die beliebige Bitfolge aufweist. Diese beliebige Bitfolge wird sodann aus dem Ausgangsdatenstrom ausgelesen und in einem ersten Verfahrensschritt bereitgestellt.

Typischerweise kann der Ausgangsdatenstrom beziehungsweise die Ausgangsbitfolge so viele Bits aufweisen, dass das Verfahren derart iterativ durchgeführt wird, dass mehrere beliebige Bitfolgen aus der Ausgangsbitfolge erzeugt werden, segmentiert werden, in Teilsymbole überführt werden, bezüglich der Disparität optimiert werden und sodann übertragen werden. Somit kann auch die Ausgangsbitfolge beliebig lang sein und kann in mehreren Gesamtsymbolen letztendlich übertragen werden.

Die Kodiereinheiten liegen in Mehrzahl vor, wobei jedem Segment, welches wiederum eines Teils der beliebigen beziehungsweise vorab frei wählbaren Bitfolge entspricht, eine Kodiereinheit zugeordnet ist. Diese überführt das Segment sodann in ein Teilsymbol, wobei die Menge der Teilsymbole konkateniert das Symbol beziehungsweise das Gesamtsymbol der effizient zu übertragenden Bitfolge entspricht. Somit liegt also gemäß einem Aspekt der vorliegenden Erfindung in einem logischen Pfad der Verarbeitungskette beziehungsweise der strukturellen Anordnung zwischen einem Segment und einem Teilsymbol eine Kodiereinheit.

Das vorgeschlagene Verfahren ist besonders effizient, da die übertragbare Bitfolge verglichen mit dem Stand der Technik einen besonders hohen Grad an Nutzdaten aufweist. Beispielsweise ist es möglich 128 Bit zu übertragen, welche 112 Bit Nutzdaten aufweisen. Somit ist das vorgeschlagene Verfahren in diesem Aspekt dem Stand der Technik bereits überlegen. Darüber hinaus ist die Erstellung der übertragbaren Bitfolge besonders effizient, da dies parallelisiert erfolgen kann und hierzu Kodiereinheiten verwendet werden können, die besonders einfach ausgestaltet sind. Einfach heißt in diesem Zusammenhang zum Beispiel, dass besonders wenige Schaltungen in den Kodiereinheiten verbaut werden müssen. Die Kodiereinheiten müssen keine umfangreiche Logik aufweisen und können sogar für eine bestimmte Anzahl an Bit optimiert werden. So ist es erfindungsgemäß möglich, dass der Eingang und der Ausgang der jeweiligen Kodiereinheit bezüglich der Bitanzahl festgelegt ist.

Aufgrund der optimierten Disparität der zu übertragenden Bitfolge ist es möglich, dass Fehler bei einem Interpretieren auf einem seriellen Kanal vermieden werden. Somit bezieht sich die Effizienz auch darauf, dass die Bitfolge besonders fehlerrobust ist und somit kann diese verlässlicher Weise lediglich einmal übertragen werden. Eine redundante Übertragung wird aufgrund der hohen Erkennbarkeit, wiederum aufgrund der optimierten Disparität, vermieden.

Bei der seriellen Übertragung von Daten ist es vorteilhaft, die Anzahl von Einsen und Nullen im seriellen Datenstrom möglichst in gleicher Anzahl vorzuhalten. Dies wird generell als Disparität bezeichnet. Für eine zuverlässige Taktwiederherstellung am Empfänger kann der erzeugten Kanalsequenz eine Lauflängenbeschränkung auferlegt werden. Hierdurch wird die maximale Anzahl aufeinanderfolgender Einsen und Nullen begrenzt. Somit kann das vorgeschlagene Verfahren auch als ein Verfahren zum effizienten Kodieren einer Bitfolge bezeichnet werden. Erfindungsgemäß wird die Disparität durch ein geschicktes Einstellen von Teil- Disparitäten optimiert. Dies kann besonders vorteilhaft dann Anwendung finden, wenn die Lauflänge der Bitfolge beschränkt ist. Die eingeschränkte Disparität und die eingeschränkte Lauflänge können sich auch auf die bereitgestellte beliebige Bitfolge beziehen. Somit muss es sich hierbei nicht um die effizient übertragbare Bitfolge handeln. Insgesamt ist die bereitgestellte beliebige Bitfolge effizient übertragbar bzw. aus dieser Bitfolge wird eine zu übertragende Bitfolge generiert bzw. erzeugt, welche sodann effizient übertragbar ist.

In einem vorbereitenden Verfahrensschritt erfolgt ein Bereitstellen einer beliebigen Bitfolge, welche Nutzdaten kodiert. In dieser beliebigen Bitfolge können Probleme auftreten, welche beispielsweise darin bestehen, dass eine unvorteilhafte Disparität gegeben ist. So können zu viele Nullen bei einem Übertragen zu Problemen führen. Dies ist zu vermeiden und somit wird in weiteren Verfahrensschritten die beliebige Bitfolge derart optimiert, dass diese nunmehr effizient zu übertragen ist. Die bereitgestellte beliebige Bitfolge stellt also irgendwelche Nutzdaten dar, die von einem Sender an einen Empfänger über einen seriellen Datenkanal gesendet werden sollen. Bei der beliebigen Bitfolge kann es sich beispielsweise um Steuerdaten in einem Automobil handeln.

Erfindungsgemäß erfolgt eine Segmentierung der bereitgestellten Bitfolge in eine vorab definierte Folge von Segmenten gemäß einer jeweils vorab definierten Bit Länge. Somit wird also der Eingabedatenstrom, also die beliebige Bitfolge, gemäß einem vordefinierten Verfahren aufgeteilt, sodass einzelne Datensegmente entstehen. Die Segmente ergeben also kumuliert die beliebige Bitfolge. Die vorab definierte Bit Länge hat den Vorteil, dass Kodiereinheiten genauso optimiert werden können, dass die jeweilige Bit Länge berücksichtigt wird. Somit können besonders effiziente Schaltungen geschaffen werden, die hoch spezialisiert sind. Im Weiteren werden definierte Bit Längen genannt, welche jedoch lediglich beispielhaft sind.

Es erfolgt ein Kodieren jedes Segments in jeweils ein Teilsymbol unter Verwendung jeweils einer Kodiereinheit je Segment aus einer Mehrzahl von Kodiereinheiten. Das Kodieren an sich erfolgt in jeweils einer Kodiereinheit, welche jeweils ein Segment am Eingang vorfindet und sodann dieses Segment in ein Teilsymbol überführt. Bei dem Teilsymbol handelt es sich ebenfalls um eine Bitfolge. Insgesamt wird also die beliebige Bitfolge in Segmente unterteilt, diese Segmente werden durch jeweils eine Kodiereinheit in ein Teilsymbol überführt und die Gesamtheit der Teilsymbole ergibt die zu übertragende Kodierung der beliebigen Bitfolge. Insgesamt ist es vorteilhaft, dass die Anzahl der Segmente der Anzahl der Kodiereinheiten entspricht und somit der Anzahl der Teilsymbole. Somit ist es möglich, dass jedes Segment genau eine Kodiereinheit vorfindet, welche wiederum aus dem Segment genau ein Teilsymbol erzeugt. Die Mehrzahl von Kodiereinheiten beschreibt alle zu verwendenden Kodiereinheiten, die der Anzahl der Segmente entspricht. Die Anzahl der Segmente ist vordefiniert, da eine vorab definierte Bit Länge vorgegeben ist. Somit ist das Verfahren also insgesamt deterministisch.

Damit sich insgesamt eine vorteilhafte Disparität einstellt gibt es eine erste Teilmenge von Kodiereinheiten, welche ein Vorzeichen der Disparität des Teilsymbols durch Invertieren der Disparität des erzeugten Teilsymbols zum Ausgleich einer Disparität einer zweiten Teilmenge von Kodiereinheiten aktiv steuert. Dies bedeutet also, dass es Teilmengen von Kodiereinheiten gibt, welche das Vorzeichen der Disparität steuern oder eben nicht. Kodiereinheiten der ersten Teilmenge steuern dieses Vorzeichen und Kodiereinheiten der zweiten Teilmenge steuern diese nicht. Somit können Kodiereinheiten der ersten Teilmenge als aktiv bezeichnet werden und Kodiereinheiten der zweiten Teilmenge als passiv. Durch die unterschiedlichen Teilmengen bzw. Typen von Kodiereinheiten ist es möglich die Kodiereinheiten derart in Serie zu schalten, dass Kodiereinheiten der ersten Teilmenge die Gesamtdisparität auch der Teilsymbole aus den Kodiereinheiten der zweiten Teilmenge vorteilhaft ausgestalten.

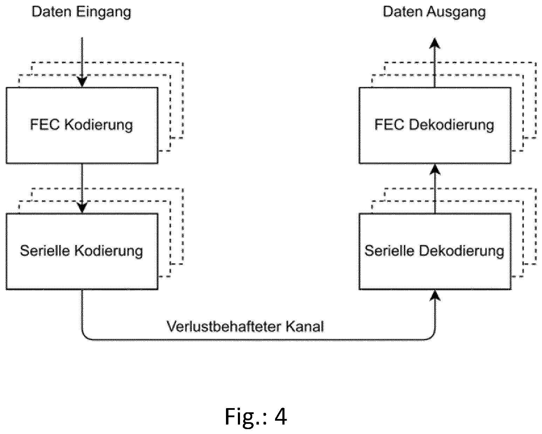

Erfindungsgemäß werden also Kodiereinheiten verwendet, die bezüglich der Disparität des Teilsymbols beliebig sind. Sodann kann eine Kodiereinheit der ersten Teilmenge parallelgeschaltet werden, welches in Abhängigkeit der Disparität der Kodiereinheit der zweiten Teilmenge das Vorzeichen der Disparität der vorhergehenden Kodiereinheit und der eigenen Kodiereinheit bzw. deren Teilsymbole steuert. Somit wird eine bestimmte Anzahl von Kodiereinheiten der zweiten Teilmenge verwendet und sodann wird eine weitere bestimmte Anzahl von Kodiereinheiten der ersten Teilmenge verwendet. Hierdurch wechseln sich die Typen bzw. Teilmengen der Kodiereinheiten derart, sodass die jeweils nächste parallel geschaltete Kodiereinheit die Disparität des bzw. der vorhergehenden Teilsymbole und/ oder des eigenen Teilsymbols anpasst. Auf diese Art und Weise wird vermieden, dass nicht steuerbare Kodiereinheiten derart hintereinander parallelgeschaltet werden, dass sich eine ungünstige Disparität einstellt. Jede Kodiereinheit der ersten Teilmenge korrigiert somit das Vorzeichen der vorhergehend parallelgeschalteten Kodiereinheiten bzw. deren Teilsymbole. Im Folgenden wird dieses Parallelschalten von Kodiereinheiten noch näher in Bezug auf Figur 4 beschrieben.

Zusammenfassend lässt sich also folgern, dass Kodiereinheiten der ersten Teilmenge jeweils Kodiereinheiten der zweiten Teilmenge bezüglich der Disparität optimieren. Ein Optimieren einer Disparität heißt, dass die Disparität 0 ist. Wie der Fachmann Disparitäten berechnet bzw. diese einstellt, beispielsweise durch Vorzeichenwechseln, ist dem Fachmann hinreichend bekannt.

Gemäß dem vorgeschlagenen Verfahren werden also Teilsymbole geschaffen, welche in ihrer Sequenz bezüglich der Disparität optimiert sind. Da jedes Segment in ein Teilsymbol überführt wird, kann durch ein Aneinanderreihen der Teilsymbole das (Gesamt)-Symbol erzeugt werden, welches zu übertragen ist. Dieses kann besonders effizient bzw. fehlertolerant übertragen werden, da eben die Disparität bzw. die Teil Disparitäten optimiert sind. In dieser Art und Weise ergibt sich eine besonders vorteilhaft zu übertragende Bitfolge.

Gemäß einem Aspekt der vorliegenden Erfindung ist die beliebige Bitfolge in ihrer Disparität und Lauflänge uneingeschränkt. Dies hat den Vorteil, dass jede beliebige Menge an Nutzdaten übermittelt werden kann bzw. in eine Bitfolge überführt werden kann, welche in der Disparität eingeschränkt und in der Lauflänge eingeschränkt ist. Somit wird also eine beliebige Bitfolge in eine zu übertragende Bitfolge kodiert, die in ihrer Disparität und Lauflänge optimiert ist.

Gemäß einem weiteren Aspekt der vorliegenden Erfindung ist die Disparität der zweiten Teilmenge von Kodiereinheiten nicht steuerbar. Dies hat den Vorteil, dass anhand der Kodiereinheiten der zweiten Teilmenge ein beliebiges Teilsymbol erzeugt werden kann, wobei besonders einfache Kodiereinheiten zu verwenden sind. Diese können besonders einfach ausgestaltet werden, da das erzeugte Teilsymbol dieser Kodiereinheit keinerlei Beschränkung bezüglich der Disparität oder Lauflänge unterliegt.

Gemäß einem weiteren Aspekt der vorliegenden Erfindung erfolgt das aktive Steuern des Vorzeichens jeweils mittels bedingten Invertierens des Teilsymbols. Dies hat den Vorteil, dass auf einfache Art und Weise das entsprechende Teilsymbol der Kodiereinheiten der ersten Teilmenge gesteuert werden kann. Es muss lediglich die Disparität beziehungsweise einzelne Bits des Teilsymbols invertiert werden. Das Vorzeichen bezieht sich auf die Disparität des Teilsymbols, welches positiv oder negativ sein kann.

Gemäß einem weiteren Aspekt der vorliegenden Erfindung erfolgt das bedingte Invertieren in Abhängigkeit der Disparität eines Gesamtsymbols, welches aus allen Teilsymbolen gebildet wird. Dies hat den Vorteil, dass nicht nur Teilsymbole optimiert werden, sondern es werden auch die gesamten, also die zusammengesetzten Teilsymbole, insgesamt also das Gesamtsymbol bezüglich der Disparität optimiert. Hierdurch entsteht ein besonders vorteilhaftes Gesamtsymbol.

Gemäß einem weiteren Aspekt der vorliegenden Erfindung wird die Abhängigkeit derart beeinflusst, dass ein Betragswert der Disparität minimiert wird. Dies hat den Vorteil, dass eine möglichst niedrige Disparität, vorzugsweise 0, erreicht wird. Es werden also Disparitäten derart miteinander verknüpft, dass der Betrag der Disparitäten möglichst 0 bzw. möglichst gering ist.

Gemäß einem weiteren Aspekt der vorliegenden Erfindung wird der Betragswert derart minimiert, dass bei positiver Gesamtsymbol Disparität durch eine negative Parität der Teilsymbole entgegengesteuert wird. Dies hat den Vorteil, dass die positive Gesamtsymbole Disparität minimiert bzw. eliminiert wird.

Gemäß einem weiteren Aspekt der vorliegenden Erfindung wird der Betragswert derart minimiert, dass bei negativer Gesamtsymbol Disparität durch eine positive Parität der Teilsymbole entgegengesteuert wird. Dies hat den Vorteil, dass die Gesamtsymbol Disparität insgesamt minimiert bzw. eliminiert wird.

Gemäß einem weiteren Aspekt der vorliegenden Erfindung erfolgt das aktive Steuern in Abhängigkeit von bereits übertragener Gesamtsymbole, derart dass die Disparität aller Gesamtsymbole minimiert wird. Dies hat den Vorteil, dass mehrere Gesamtsymbole bezüglich ihrer Disparität minimiert werden bzw. die Disparität eliminiert wird und somit werden auch mehrere Folgen von Gesamtsymbolen bezüglich ihrer Übertragbarkeit optimiert.

Gemäß einem weiteren Aspekt der vorliegenden Erfindung, kodieren Kodiereinheiten der ersten Teilmenge Segmente von 11 Bit auf Teilsymbole von 13 Bit. Dies hat den Vorteil, dass 11 Bit besonders effizient kodiert werden und hierzu lediglich ein Mehraufwand von 2 Bit entsteht. Dies ist insbesondere dann vorteilhaft, wenn ein Gesamtsymbol von 128 Bit geschaffen werden soll. Generell wurden die vorliegend genannten konkreten Werte der vorgeschlagenen technischen Lehre empirisch ermittelt und können dadurch belegt werden, dass lediglich ein zusätzlicher Aufwand von 128 - 112 Bit, also 14 % notwendig ist. Somit sind die hier aufgeführten Werte nachgewiesener Weise vorteilhaft bei einem Übertragen von 112 Bit.

Gemäß einem weiteren Aspekt der vorliegenden Erfindung weisen Kodiereinheiten der ersten Teilmenge eine Disparität zwischen +3 und +9 auf, welche durch Invertieren gezielt auf -3 bis -9 invertiert werden. Dies hat den Vorteil, dass beispielsweise eine Disparität von +3 mit einer Disparität von -3 aufgehoben wird, was analog bei einer Anpassung der Disparität von +9 mit einer Disparität von -9 erfolgt. Dies ist wiederum insbesondere bei einer beliebigen Bit Folge von 112 Bit besonders vorteilhaft, welche als 128 Bit kodiert werden soll.

Gemäß einem weiteren Aspekt der vorliegenden Erfindung beträgt die Lauflänge in Teilsymbolen maximal 7. Dies hat den Vorteil, dass maximal 7 gleiche Instanzen von Nullen und Einsen erzeugt werden, was im vorgeschlagenen Szenario von 112 Bit bzw. 128 Bit besonders vorteilhaft ist.

Gemäß einem weiteren Aspekt der vorliegenden Erfindung beträgt die Lauflänge des Teilsymbols bei Kodiereinheiten der ersten Teilmenge ausgehend vom höchstwertigsten und/ oder vom niederwertigsten Bit maximal 5. Dies hat den Vorteil, dass am Ende bzw. am Anfang eines Teilsymbols maximal 5 gleiche Bit vorliegen können. Dies hat sich im beschriebenen Szenario ebenfalls als besonders vorteilhaft erwiesen.

Gemäß einem weiteren Aspekt der vorliegenden Erfindung werden bei Kodiereinheiten der zweiten Teilmenge 11 Bit- Segmente auf 12 Bit Teilsymbole oder 7 Bit- Segmente auf 8 Bit Teilsymbole oder 6 Bit- Segmente auf 8 Bit Teilsymbole kodiert. Dies hat den Vorteil, dass anhand dieser Kodierung in dem Szenario von zu übertragenden 112 Bit in einem Symbol von 128 Bit besonders vorteilhafte Werte entstehen, die einen minimierten Überhang von lediglich 14 % aufweisen.

Gemäß einem weiteren Aspekt der vorliegenden Erfindung wird bei Kodiereinheiten der zweiten Teilmenge eine Disparität zwischen -2 und +2 erzeugt. Dies hat den Vorteil, dass wiederum besonders vorteilhafte Disparitäten erzeugt werden.

Gemäß einem weiteren Aspekt vorliegenden Erfindung ist bei Kodiereinheiten der zweiten Teilmenge die Lauflänge im erzeugten Teilsymbol 6. Dies hat den Vorteil, dass wiederum besonders optimierte Teilsymbole erzeugt werden.

Gemäß einem weiteren Aspekt der vorliegenden Erfindung erzeugen Kodiereinheiten der zweiten Teilmenge Teilsymbole, welche am Rand eine Lauflänge von maximal 3 aufweisen. Dies hat den Vorteil, dass Teilsymbole, welche durch die zweite Teilmenge von Kodiereinheiten geschaffen werden am Anfang bzw. am Ende eine Lauflänge von maximal 3 aufweisen, was ein besonders vorteilhafter Wert ist.

Gemäß einem weiteren Aspekt vorliegenden Erfindung werden die Kodiereinheiten parallel angesprochen und jeweils ein Segment in ein Teilsymbol kodiert. Dies hat den Vorteil, dass ein Segment in genau ein Teilsymbol mit genau einer Kodiereinheit überführt wird. Somit können also die Kodiereinheiten parallel angesprochen werden, da aus der beliebigen Bitfolge Segmente gebildet werden, welche parallel in Teilsymbole überführt werden können.

Gemäß einem weiteren Aspekt der vorliegenden Erfindung werden die Kodiereinheiten in der Reihenfolge 21212221212 angesprochen, wobei eine 1 für eine Kodiereinheit der ersten Teilmenge steht und eine 2 für eine Kodiereinheit der zweiten Teilmenge. Dies hat den Vorteil, dass auf eine nicht aktiv gesteuerte Anzahl von Kodiereinheiten stets eine einzige Kodiereinheit folgt, welche aktiv gesteuert werden kann. Hierzu wurde empirisch ermittelt, dass gerade bei den vorgeschlagenen Kodiereinheiten ein besonders vorteilhaftes Gesamtsymbol resultiert.

Gemäß einem weiteren Aspekt der vorliegenden Erfindung wird ein Multiplexer bei einem Anlegen eines bezüglich der Disparität positiven Datenstroms und eines negativen Datenstroms denjenigen Datenstrom aus, der zur Minimierung der Gesamtdisparität des Gesamtsymbols beiträgt. Dies hat den Vorteil, dass der geeignete Datenstrom gewählt werden kann, welcher ein Vorzeichen aufweist, welches die Disparität minimiert bzw. eliminiert. Ist beispielsweise die zu optimierende Disparität negativ, so wird ein Datenstrom mit positiver Disparität gewählt, der sodann diesen Datenstrom eben bezüglich dessen Disparität minimiert bzw. ausgleicht.

Erfindungsgemäß wird die Vorwärtsfehlerkorrektur dadurch verbessert, dass diese bezüglich Nutzdaten errechnet wird und dass hierzu erst die Nutzdaten segmentiert werden. Für jedes Segment wird sodann eine eigene Vorwärtsfehlerkorrektur berechnet, sodass sich die Vorwärtsfehlerkorrektur nicht auf ein gesamtes Datenwort bezieht, sondern auf unterschiedliche Teilwörter. Hierdurch wird die Gatteranzahl der zu verwendenden FEC Kodierer gering gehalten und es wird ein exponentielles Wachstum vermieden. Darüber hinaus ergibt sich eine Verbesserung dadurch, dass erfindungsgemäß eine Leitungskodierung über die Nutzdaten mitsamt der Vorwärtsfehlerkorrektur erfolgt und somit wird der Nachteil im Stand der Technik überwunden, dass die Vorwärtsfehlerkorrektur in einer nicht kodierten Form übermittelt wird. Weiterhin ist es vorteilhaft, dass die Fehlerkorrektur effizienter arbeiten kann, da sich die Fehlerkorrektur lediglich auf Teilwörter bezieht und somit feingranular erkannt werden kann, wo ein Fehler aufgetreten ist. Herkömmliche Fehlerkorrekturen beziehen sich stets auf gesamte Datenwörter und sind daher ineffizient bzw. kann es in dem Stand der Technik zu Fehlern kommen die nicht korrigierbar sind. Dies wird durch die Segmentierung erfindungsgemäß vermieden.

Eine weitere Verbesserung besteht darin, dass alle übertragenen Daten leitungskodiert werden und somit kann die Gesamtheit der Daten von der Leitungskodierung profitieren. Der Übertragungslink ist somit deterministisch kontrollierbar und die Bitfehler werden minimal gehalten. Darüber hinaus ergibt sich eine implizite Verschachtelung daraus, dass kleinere Pakete versendet werden und somit kommt es implizit zu einer Verschachtelung, da nicht die gesamten Datenwörter übertragen werden. Dies wird dadurch erreicht, dass mehrere Vorwärtsfehlerkorrekturkodierer verwendet werden, die sich jeweils nur auf Teilwörter beziehen. Somit wird erfindungsgemäß der Nachteil im Stand der Technik überwunden, dass aufwendig eine explizite Verschachtelung geschaffen werden muss, welche zudem weitere Pufferspeicher benötigen würde.

Aufgrund der optimierten Disparität (Leitungskodierung) der zu übertragenden Bitfolge ist es möglich, dass Fehler bei einem Interpretieren auf einem seriellen Kanal vermieden werden. Somit bezieht sich die Effizienz auch darauf, dass die Bitfolge besonders fehlerrobust ist und somit kann diese verlässlicher Weise lediglich einmal übertragen werden. Eine redundante Übertragung wird aufgrund der hohen Erkennbarkeit, wiederum aufgrund der optimierten Disparität, vermieden.

Bei der seriellen Übertragung von Daten ist es vorteilhaft, die Anzahl von Einsen und Nullen im seriellen Datenstrom möglichst in gleicher Anzahl vorzuhalten. Dies wird generell als Disparität bezeichnet. Für eine zuverlässige Taktwiederherstellung am Empfänger kann der erzeugten Kanalsequenz eine Lauflängenbeschränkung auferlegt werden. Hierdurch wird die maximale Anzahl aufeinanderfolgender Einsen und Nullen begrenzt. Somit kann das vorgeschlagene Verfahren auch als ein Verfahren zum effizienten Kodieren einer Bitfolge bezeichnet werden. Erfindungsgemäß wird die Disparität durch ein geschicktes Einstellen von Teil- Disparitäten optimiert. Dies kann besonders vorteilhaft dann Anwendung finden, wenn die Lauflänge der Bitfolge beschränkt ist. Die eingeschränkte Disparität und die eingeschränkte Lauflänge können sich auch auf die bereitgestellte beliebige Bitfolge beziehen. Somit muss es sich hierbei nicht um die effizient übertragbare Bitfolge handeln. Insgesamt ist die bereitgestellte beliebige Bitfolge effizient übertragbar bzw. aus dieser Bitfolge wird eine zu übertragende Bitfolge generiert bzw. erzeugt, welche sodann effizient übertragbar ist.

Das vorgeschlagene Verfahren ist speziell im Fahrzeug einsetzbar bzw. speziell auf den Bedarf im Fahrzeug zugeschnitten. Dies ist deshalb der Fall, da im Fahrzeug sicherheitskritische Funktionen angeboten werden, welche entsprechend abgesichert werden müssen. Erfindungsgemäß erfolgt das in mehrfacher Weise. Zum einen durch die Vorwärtsfehlerkorrektur sowie über die Leitungskodierung. Darüber hinaus wirkt sich gerade in der Elektromobilität die verringerte Anzahl an benötigten Gattern vorteilhaft aus.

Erfindungsgemäß erfolgt in einem vorbereitenden Verfahrensschritt ein Bereitstellen von zu übertragenden Nutzdaten. Hierbei handelt es sich typischerweise um eine Bitfolge in festgelegter Länge. Dies kann auch als ein Datenwort bezeichnet werden.

Sodann erfolgt ein Aufteilen der bereitgestellten Nutzdaten in eine Mehrzahl von Bitfolgen jeweils gleicher Länge. Diese Bitfolgen können in einem bevorzugten Ausführungsbeispiel eine Länge von 112 Bit aufweisen. Während es sich bei den Nutzdaten um einen kontinuierlichen Datenstrom handeln kann, sind die Bitfolgen stets von bestimmter Länge und stellen in gewisser Weise eine Unterteilung der Nutzdaten bereit. Im Folgenden wird eine Bitfolge auch als ein Datenwort bezeichnet. Weiterhin wird im Folgenden, insbesondere auch in den Figuren, davon ausgegangen, dass bildlich gesprochen die Bitfolgen untereinander angeordnet werden. Somit erstreckt sich also jede einzelne Bitfolge horizontal und vertikal werden die einzelnen Bitfolgen untereinander angeordnet.

Da die Bitfolgen nunmehr segmentiert werden, erfolgt ein Auslesen einer Unterteilungsvorschrift, welche eine Bitfolge in eine Abfolge von Segmenten jeweils vordefinierter Länge an vorbestimmter Position unterteilt. Die Unterteilungsvorschrift kann als ein Datenformat vorliegen, welches definiert, wie lange ein Segment sein muss. Hierbei müssen die einzelnen Segmente nicht gleicher Länge sein, sondern dies kann von Segment zu Segment variieren. Die Unterteilungsvorschrift sieht jedoch vor, dass die einzelnen Bitfolgen je vom gleichen Format sind, so dass sich bildlich gesprochen vertikal gleiche Unterteilungen ergeben. So kann beispielsweise ein erstes Segment jeder Bitfolge 11 Bit aufweisen. Beispielsweise können auch die ersten vier Segmente jeweils 11 Bit aufweisen, woraufhin ein Segment von 7 Bit folgt. Daraufhin kann wieder ein Segment mit 11 Bit vorgesehen sein und dann ein Segment von 6 Bit. Dieses Datenformate wird für alle Bitfolgen eingehalten. Somit können also die Segmente an gleicher Position immer von gleicher Länge sein, wobei sich die Segmente bildlich gesprochen vertikal unterscheiden können. Die Segmente bildlich gesprochen je Zeile formen sodann die Bitfolge. Die Bitfolgen in ihrer vertikalen Anordnung bilden in ihrer Gesamtheit die Nutzdaten.

Somit erfolgt also ein Anwenden der ausgelesenen Unterteilungsvorschrift auf alle Bitfolgen der Mehrzahl von Bitfolgen, bis die gesamten Nutzdaten horizontal gesprochen in Bitfolgen zerlegt sind und vertikal die Segmente gebildet sind. Somit werden also alle Bitfolgen gemäß gleicher Unterteilungsvorschrift unterteilt. Die Unterteilungsvorschrift kann aus einem Datenspeicher ausgelesen werden und gilt für alle Bitfolgen, die aus den Nutzdaten gewonnen worden.

Nunmehr erfolgt ein iteratives Erstellen jeweils einer Teilvorwärtsfehlerkorrektur für alle Segmente gleicher Bitposition über alle Bitfolgen. Somit wird also wiederum bildlich gesprochen für alle vertikalen Segmente eine Vorwärtsfehlerkorrektur berechnet, die sich also auf alle Segmente an gleicher Bitposition bzw. gleicher Reihenfolge befinden. Dies wird für alle Segmente durchgeführt, sodass über alle Bitfolgen und somit über die kompletten Nutzdaten jeweils Teilvorwärtsfehlerkorrekturen erstellt wurden. Die Gesamtheit aller Teilvorwärtsfehlerkorrekturen schafft somit eine gesamte Vorwärtsfehlerkorrektur, die sich auf die kompletten Nutzdaten bzw. alle Bitfolgen bezieht.

Generell ist es auch möglich, dass die Nutzdaten lediglich in eine Bitfolge aufgeteilt werden bzw. dass die Nutzdaten bereits in ihrer Länge als eine Bitfolge vorliegen. Somit wird dann für jedes Segment eine Teilvorwärtsfehlerkorrektur erzeugt.

Nunmehr erfolgt ein iteratives Anwenden jeweils eines Segmentkodierers über jeweils alle Segmente gleicher Bitposition zur Erzeugung von Segmentleitungskodes über alle Segmente je Bitposition und je Bitfolge. Es erfolgt also eine Leitungskodierung über bildlich gesprochen alle vertikalen Segmente. Dies ist insofern vorteilhaft, da Leitungskodierer speziell für vorbestimmte Längen vorgesehen werden. Hierdurch wird sichergestellt, dass die vertikalen Segmente jeweils durch einen einzelnen Leitungskodierung kodiert werden können. Das iterative Anwenden der Segmentkodierer stellt also sicher, dass bildlich gesprochen spaltenweise die Segmente leitungskodiert werden und dies erfolgt über alle Segmente derart, bis alle Bitfolgen bezüglich ihrer Segmente leitungskodiert sind.

Besonders vorteilhaft ist es, dass die Teilvorwärtsfehlerkorrektur die gleiche Anzahl aufweist, wie die jeweiligen Segmente. Somit kann die Teilvorwärtsfehlerkorrektur mittels des gleichen Leitungskodierers kodiert werden, wie die entsprechenden Segmente.

Es erfolgt ein Anwenden jeweils desjenigen Segmentkodierers auf die jeweilige

Teilvorwärtsfehlerkorrektur, der auch für die Segmente angewendet wurde bezüglich derer die jeweilige Teilvorwärtsfehlerkorrektur erstellt wurde zur Erzeugung jeweils eines Teilvorwärtsfehlerkorrekturleitungskodes je Teilvorwärtsfehlerkorrektur. Somit werden also diejenigen Segmentkodierer verwendet, die die jeweiligen Segmente leitungskodiert haben und sodann auch die jeweiligen Teilvorwärtsfehlerkorrekturen leitungskodieren. Somit werden also die Segmente spaltenweise mit dem gleichen Segmentkodierer leitungskodiert wie die Teilvorwärtsfehlerkorrekturen, die sich auf die jeweilige Spalte beziehen.

Daraufhin erfolgt eine Übertragung aller Segmentleitungskodes und aller Teilvorwärtsfehlerkorrekturleitungskodes.

Gemäß einem Aspekt der vorliegenden Erfindung wird die Unterteilungsvorschrift in einem Datenspeicher abgespeichert und liegt als eine Kodierungsvorschrift vor und/ oder wird aus einer Hardwarearchitektur ausgelesen. Dies hat den Vorteil, dass die Unterteilungsvorschrift statisch vorgegeben sein kann bzw. auch in dem Datenspeicher geändert werden kann. Darüber hinaus kann die Unterteilungsvorschrift auf die entsprechende Hardwarearchitektur Rücksicht nehmen. Werden beispielsweise unterschiedliche Kodierer für unterschiedliche Bitlängen vorgehalten, so können die Bitfolgen derart unterteilt werden, dass die entsprechenden Segmente den jeweiligen Kodierern entsprechen. Die Segmente haben also genau diese Länge, die der jeweilige Kodierer vorsieht.

Gemäß einem weiteren Aspekt der vorliegenden Erfindung weisen alle Bitfolgen in ihrem Datenformat den gleichen Aufbau auf, haben die gleichen Segmentlängen und/ oder die gleichen Bitpositionen. Dies hat den Vorteil, dass die einzelnen Segmente den jeweiligen Kodierern zugeführt werden können. So wird beispielsweise jedes erste Segment jeder Bitfolge dem gleichen Kodierer zugeführt. Somit können bildlich gesprochen die Segmente spaltenweise kodiert werden und es liegt für jede Spalte ein spezialisierter Kodierer vor.

Gemäß einem weiteren Aspekt der vorliegenden Erfindung weist die Teilvorwärtsfehlerkorrektur eine Korrekturinformation auf, welche einen Sollinhalt des Segments beschreibt über das die Teilvorwärtsfehlerkorrektur erstellt wurde. Dies hat den Vorteil, dass mittels dieser Korrekturdaten die übermittelten Daten korrigiert werden können, wobei nicht für jede Bitfolge eine gesamte Korrektur gebildet wird, sondern vielmehr werden für die einzelnen Segmente einzelne Teilvorwärtsfehlerkorrekturen gebildet. Alle Teilvorwärtsfehlerkorrekturen in ihrer Gesamtheit beschreiben alle Segmente aller Bitfolgen und somit alle Nutzdaten. Der Unterschied zum Stand der Technik hierbei ist jedoch, dass nicht für jede Bitfolge eine Vorwärtsfehlerkorrektur gebildet wird, sondern für alle Segmente über alle Bitfolgen. Somit ist es möglich für jede Teilvorwärtsfehlerkorrektur den gleichen Leitungskodierer zu verwenden, der für die entsprechenden Segmente verwendet wird.

Gemäß einem weiteren Aspekt der vorliegenden Erfindung weist die Teilvorwärtsfehlerkorrektur die gleiche Bitlänge auf wie das Segment über welches diese erstellt wird. Dies hat den Vorteil, dass spezialisierte Leitungskodierer vorgehalten werden können und somit wird eine maximale Effizienz dahingehend geschaffen, dass die entsprechenden spaltenweisen Leitungskodierer genau für die Bitlänge spezialisiert sind, die sie sodann auch kodieren müssen. Somit wird ein effizientes und technisch minimal aufwändiges Verfahren geschaffen.

Gemäß einem weiteren Aspekt der vorliegenden Erfindung beschreibt eine Gesamtheit der Teilvorwärtsfehlerkorrekturen alle zu übertragenden Nutzdaten in korrigierbarer Weise. Dies hat den Vorteil, dass alle Nutzdaten, welche übertragen werden bezüglich ihrer Fehler korrigiert werden können, hierbei jedoch auf die einzelnen Segmente abgestellt werden kann, so dass das vorgeschlagene Verfahren feingranularer ist, als dies der Stand der Technik vorsieht.

Gemäß einem weiteren Aspekt der vorliegenden Erfindung erzeugen die Segmentkodierer jeweils mindestens einen Teil eines Leitungskodes. Dies hat den Vorteil, dass die Ausgaben der Segmentkodierer zusammengefügt werden können und sodann die zu übertragenden Leitungskodes bereitstellen.

Gemäß einem weiteren Aspekt der vorliegenden Erfindung kodiert die Gesamtheit der Segmentkodierer Bitfolgen von 112 Bit in Wörter von 128 Bit. Dies hat den Vorteil, dass ein besonders effizienter Line Code bzw. Leitungskode geschaffen wird.

Gemäß einem weiteren Aspekt der vorliegenden Erfindung werden bei dem Übertragen an die Segmentleitungskodes die Teilvorwärtsfehlerkorrekturleitungskodes angehängt. Dies hat den Vorteil, dass alle zu übertragenden Daten leitungskodiert sind und somit wird die Leitung deterministisch betrieben bzw. die Vorteile der Leitungskodierung kann für alle Daten in Anspruch genommen werden und eben nicht nur für die Nutzdaten an sich.

Gemäß einem weiteren Aspekt der vorliegenden Erfindung ist die Bitposition als ein Offset oder als ein Bitindex in der Bitfolge angegeben. Dies hat den Vorteil, dass unterschiedliche Adressierungsarten verwendet werden können und der Index auf eine Reihenfolge der jeweiligen Segmente abstellt, welche sodann vorteilhaft und unter Verwendung von bekannten Verfahren angegeben werden kann.

Gemäß einem weiteren Aspekt der vorliegenden Erfindung liegen die Nutzdaten als ein serieller Datenstrom vor. Dies hat den Vorteil, dass theoretisch eine beliebige Menge an Nutzdaten übertragen werden kann, welche sodann in Bitfolgen gleicher Länge unterteilt wird.

Gemäß einem weiteren Aspekt der vorliegenden Erfindung werden die Verfahrensschritte in der beschriebenen Reihenfolge ausgeführt und/ oder iterativ ausgeführt. Dies hat den Vorteil, dass die Reihenfolge der Kodierung umgekehrt wird. Erfindungsgemäß ist es vorgesehen, dass zuerst die Vorwärtsfehlerkorrektur erstellt wird und sodann erfolgt die Leitungskodierung. Dies schließt nicht aus, dass einzelne Verfahrensschritte mehrfach durchgeführt werden müssen. Dies kann beispielsweise dann sein, wenn mehrere Bitfolgen vorliegen und diese segmentiert werden müssen.

Gemäß einem Aspekt der vorliegenden Erfindung wird für jeweils jeden Datenteilwörterblock und/ oder jeweils jede Datenteilwörterblockvorwärtsfehlerkorrektur ein Leitungskodesegment erzeugt. Dies hat den Vorteil, dass gerade die Vorwärtsfehlerkorrektur nicht unkodiert übermittelt werden muss, sondern vielmehr wird auch diese leitungskodiert. Somit stehen die Vorteile der Leitungskodierung nicht nur für die Nutzdaten zur Verfügung sondern eben auch für die Vorwärtsfehlerkorrektur.

Gemäß einem weiteren Aspekt der vorliegenden Erfindung wird eine Vorwärtsfehlerkorrektur für einen Datenblock aus mehreren Teilvorwärtsfehlerkorrekturen der Datenteilwörterblöcke zusammengesetzt. Dies hat den Vorteil, dass nicht eine gesamte Vorwärtsfehlerkorrektur initial erzeugt wird, sondern viele einzelne Teilvorwärtsfehlerkorrekturen, die in ihrer Gesamtheit eine Gesamtvorwärtsfehlerkorrektur bilden. Auf diese Art und Weise wird die Gatteranzahl der benötigten FEC Kodierer minimal gehalten. Dennoch ist es möglich, alle Daten mittels einer Vorwärtsfehlerkorrektur zu schützen und darüber hinaus die Daten mitsamt Vorwärtsfehlerkorrektur FEC leitungskodiert zu übermitteln.

Gemäß einem weiteren Aspekt der vorliegenden Erfindung wird die Datenstruktur ausgelesen und in Abhängigkeit der jeweiligen Bitlängen der Datenteilwörter je ein Vorwärtsfehlerkorrekturteilkodierer gewählt. Dies hat den Vorteil, dass die FEC Kodierer genau auf die Segmentlängen bzw. die Bitlängen der Teilwörter zugeschnitten sind. Auf diese Art und Weise ist es möglich, dass die Gatteranzahl derart minimiert wird, dass die Kodierer lediglich für kleine Teilwörter Kodierungen erstellen müssen und eben nicht für die gesamten Datenwörter. Folglich ist jeder FEC Kodierer genau auf die Bitlänge des zu kodierenden Datenteilworts zugeschnitten.

Gemäß einem weiteren Aspekt der vorliegenden Erfindung wird die Anzahl der Gatter der FEC - Teilkodierer in Abhängigkeit einer Bitlänge der Datenteilwörter gewählt. Dies hat den Vorteil, dass gegenüber dem Stand der Technik die Anzahl der Gatter, die bei den FEC - Kodierern benötigt wird, reduziert wird und somit wird eine effiziente Systemanordnung bzw. ein effizientes Verfahren geschaffen, welches gerade im Automobil bzw. im Fahrzeug vorteilhaft ist. Auf diese Art und Weise müssen keine Gatter vorgehalten werden, die nicht notwendig wären. Somit hat man eine deterministische und minimale Anzahl an Gattern.

Gemäß einem weiteren Aspekt der vorliegenden Erfindung wird die Anzahl aller Gatter aller Kodierer derart gewählt, dass sich bei iterativer Ausführung des Verfahrens eine lineare Erhöhung der Gatteranzahl bezüglich ansteigender Datenwortlängen ergibt. Dies hat den Vorteil, dass unter Berücksichtigung des Datenformats eine minimale Anzahl an Gattern bereitgestellt wird bzw. dass bereits das Datenformat derart gewählt werden kann, dass nur eine lineare Steigerung bei der Anzahl der Gatter notwendig ist. So kann in einem Ausführungsbeispiel die maximale Bitlänge 10,11 oder 12 Bit sein, was dazu führt, dass die benötigten Gatter bzw. Schaltkreise der FEC Kodierer lediglich linear ansteigen. Da bei größeren Werten ein exponentielles Wachstum an Gattern notwendig ist schafft die vorliegende Erfindung den technischen Effekt, dass der Stromverbrauch bzw. die Energieaufnahme minimiert wird, was wiederum zu weniger Abwärme führt. Darüber hinaus ist das vorgeschlagene Verfahren besonders robust, was gerade im Automobil vorteilhaft ist, da hier sicherheitskritische Funktionen angeboten werden.

Gemäß einem weiteren Aspekt der vorliegenden Erfindung weist jedes Datenwort 112 Bit auf. Dies hat den Vorteil, dass bei einer Leitungskodierung Wörter von 128 Bit geschaffen werden können, was einem gängigen Format entspricht. Erfindungsgemäß wurde gezeigt, dass sich gerade 112 Bit besonders Fehler robust 128 Bit kodieren lassen. Somit ist Sorge getragen, dass der Übertragung ein verlustbehafteter bzw. fehlerbehafteter Datenkanal unterliegt.

Gemäß einem weiteren Aspekt der vorliegenden Erfindung wird die Bitlänge der Datenteilwörterblockvorwärtsfehlerkorrektur derart gewählt, dass diese mit der Bitlänge der Datenteilwörter übereinstimmt. Dies hat den Vorteil, dass sowohl die Vorwärtsfehlerkorrektur als auch die Datenteilwörter bzw. Segmente den gleichen Kodierer kodiert werden können, wobei es sich hierbei um den Leitungskodierer, also nicht den FEC Kodierer, handelt. Somit schafft die vorliegende Erfindung den technischen Beitrag, dass nicht nur eine minimale Gatteranzahl vorzuhalten ist, sondern vielmehr wird auch die Anzahl der Kodierer insgesamt minimiert. So kann die Vorwärtsfehlerkorrektur mit den gleichen Kodierer leitungskodiert werden, wie die tatsächlichen Segmente der Nutzdaten.

Gemäß einem weiteren Aspekt der vorliegenden Erfindung wird die Datenteilwörterblockvorwärtsfehlerkorrektur und der Datenteilwörterblock auf Basis dessen die Datenteilwörterblockvorwärtsfehlerkorrektur berechnet wird mittels dem gleichen Leitungskodierers leitungskodiert. Dies hat den Vorteil, dass eine minimale Anzahl an Leitungskodierung vorzuhalten ist. Bildlich gesprochen werden quasi alle Spalten, d.h. alle Teilwörterblöcke mitsamt der entsprechenden Teilvorwärtsfehlerkorrektur mit jeweils dem gleichen Segmentkodierer leitungskodiert.

Gemäß einem weiteren Aspekt der vorliegenden Erfindung wird die Datenstruktur in Abhängigkeit der Bitlänge der Datenwörter gewählt. Dies hat den Vorteil, dass dynamisch auch zur Laufzeit auf die unterschiedlichen Bitlängen eingegangen werden kann und somit kann für weitere Datenwörter das gleiche Datenformat gewählt werden, wie für ein erstes bereitgestelltes Datenwort. Liegen erste Datenwörter vor, so kann bei einem weiteren seriellen Datenstrom eine entsprechende Datenstruktur angewendet werden und die weiteren Datenwörter werden derart strukturiert, dass sie den Datenstrukturen der zuerst erhaltenen Datenwörtern entsprechen.

Gemäß einem weiteren Aspekt der vorliegenden Erfindung erfolgt eine serielle Leitungskodierung nach dem Berechnen der Datenteilwörterblockvorwärtsfehlerkorrektur. Dies hat den Vorteil, dass die Reihenfolge, wie sie im Stand der Technik vorgesehen ist, umgekehrt wird und es wird zuerst die Vorwärtsfehlerkorrektur berechnet, was dazu führt, dass diese eben auch leitungskodiert werden kann und nicht unverschlüsselt bzw. unkodiert übermittelt werden muss.

Gemäß einem weiteren Aspekt der vorliegenden Erfindung werden die Verfahrensschritte virtualisiert ausgeführt und Informationen über die zugrunde liegenden Kodierer und/ oder Gatter erzeugt. Dies hat den Vorteil, dass in einem vorbereitenden Verfahrensschritt die Ausführungen evaluiert werden können und insofern kann festgestellt werden, wie viele Gatter bzw. wie viele FEC Kodierer und/ oder Leitungskodierer vorzuhalten sind. Darüber hinaus kann das Verfahren insgesamt simuliert werden. Hardwarekomponenten können virtuell bereitgestellt werden.

Ein Aspekt der vorliegenden Erfindung ist es, mehrere Datenströme (Video, Audio und Daten) in einem Transportframe zu bündeln und seriell zu übertragen. Die unterschiedlichen Datenformate haben nicht nur unterschiedliche Bandbreitenanforderungen, sondern auch unterschiedliche Latenz-, Reassembly Teilschicht- und Bitfehlerratenanforderungen. Insbesondere die Übertragung heutiger Videodatenformate erfordert nicht nur die Übertragung der reinen Videodaten und deren Frame-Informationen, sondern auch die Unterstützung von Verschlüsselungsverfahren wie HDCP. All dies erfordert viele unterschiedliche Datenkanäle mit unterschiedlichsten Anforderungen an Bandbreite, Latenz, Reassembly Teilschicht etc. Hinzu kommt der Wunsch nach weitaus komplexeren Netzwerkarchitekturen als eine einfache Sender-Empfänger-Architektur bietet. Architekturen mit mehreren Repeatern, wo Datenpfade beginnen und enden können, Verzweigungen (Y) auch mit der Möglichkeit, Datenpfade wieder in einen Link zu integrieren, sind vorteilhaft.

Die Technologie folgt gemäß einem Aspekt der vorliegenden Erfindung dem Grundgedanken der Dienste ganz konsequent zu bündeln, bietet aber völlig neue Möglichkeiten hinsichtlich Netzwerkarchitekturen und erlaubt neue Ansätze bei der Implementierung heutiger Videoschnittstellen. Darüber hinaus kann es als universeller Datentransportschicht verwendet werden, beispielsweise auch zur Übertragung von Ethernet- oder Kameradaten oder jeglicher Art von Sensordaten.

Bei einem virtuellen Pfad nehmen alle Pakete/ Zellen denselben Pfad, im Gegensatz zu IP, wo ein Paket sein Ziel über eine andere Route erreichen könnte als vorherige und nachfolgende Pakete. Latenz und Reassembly Sublayer über einen virtuellen Pfad sind somit konstant.

Virtuelle Pfade haben außerdem den Vorteil, dass sie als Multiplexing- Ableger für unterschiedliche Dienste (Video, Audio, Ethernet) verwendet werden können, da die Eigenschaften der virtuellen Pfade unterschiedlich konfiguriert werden können, ohne dass sich die verschiedenen virtuellen Pfade gegenseitig stören.

Virtuelle Pfade verbrauchen nur dann Bandbreite, wenn tatsächlich Daten übertragen werden.

Das Konzept der virtuellen Pfade ermöglicht es auch, komplexe und weitreichende Diagnose- und Netzwerkkonfigurationsfunktionen zur Laufzeit mit eigenen (virtuellen) Datenkanälen zu realisieren.

Gemäß einem Aspekt der vorliegenden Erfindung wird eine virtuelle Pfadschicht zwischen der physikalischen Schicht (Serializer und Framer) und den verschiedenen Anwendungsdatenschnittstellen.

Diese wird gemäß einem Aspekt der vorliegenden Erfindung verwendet, um die verschiedenen Datenpfade zu Multiplexen und komplexere Architekturen mit Repeatern und Verzweigungen zu unterstützen. Dies geschieht hauptsächlich in der Zellschicht.

Ein weiterer Teil der virtuellen Pfadschicht ist gemäß einem Aspekt der vorliegenden Erfindung eine Anwendungsanpassungsschicht, die die Konvertierung von Video (Stream) oder z.B. Ethernet-(Paket-)Daten in die Zellen vornimmt. Diese Anwendungsanpassungsschicht umfasst auch die OAM-Funktionen für die Netzwerkdiagnose und -verwaltung.

Die Technologie kann gemäß einem Aspekt der vorliegenden Erfindung die Grundlage für die Übertragung einer Vielzahl von Datenformaten über eine serielle Verbindung im Auto (und anderswo) sein. Es bildet damit die Basis für eine neue Gerätegeneration.

Die hohen seriellen Bandbreiten machen es erforderlich, Architekturen, Zellformate und Schnittstellen zu definieren, die flexible interne Datenbusbreiten ermöglichen, um die Geschwindigkeit des internen Zeitsystems an die Möglichkeiten der Chiptechnologie anzupassen.

Die virtuelle Pfadschicht ist gemäß einem Aspekt der vorliegenden Erfindung die physikalische Schicht, die aus der Übertragungsteilschicht und der Teilschicht des physikalischen Mediums besteht, die Zellschicht und die Anwendungsanpassungsschicht, die die Segmentierungs- und Reassembly Sublayer und die Funktionen zum Anpassen der Datenformate an die entsprechende Anwendung enthält.

Die Hauptaufgabe besteht darin, die physikalische Verbindung zu anderen physikalischen Schichten herzustellen. Diese Verbindung ist grundsätzlich bidirektional zu verstehen. Theoretisch lässt sich diese Verbindung über verschiedenste Medien realisieren. Praktisch werden zwei serielle differenzielle GBps-Verbindungen verwendet. In dieser Schicht erfolgen die Leitungskodierung, das Einfügen von Leerzellen zur Entkopplung der Zellenrate von der Verbindungsrate und die Integration des Zellenstroms in den seriellen Rahmen.

In der Zellschicht werden die segmentierten Daten (Zell-Nutzdaten) der darüber liegenden Segmentation & Reassembly-Unterschicht mit Header, VP-Kennung und CRC zu vollständigen Zellen zusammengesetzt oder Zellen werden CRC-geprüft und die Nutzlast wird an die Segmentierungs- und Reassembly-Teilschicht weitergegeben. Hier erfolgt auch das Multiplexen der unterschiedlichen Zellströme der Anwendungsanpassungsfunktionen bzw. die Verteilung der Zellnutzlasten auf die Anwendungsanpassungsfunktionen gemäß dem VP Identifier. (Einspeisen / Ausspeisen)

In der Zellschicht erfolgt gemäß einem Aspekt der vorliegenden Erfindung auch das Multiplexing und Demultiplexing von Zellströmen in Repeatern und Splittern (Forwarding).

Die Aufgabe der Anwendungsanpassungsfunktionen besteht gemäß einem Aspekt der vorliegenden Erfindung darin, die Daten der Anwendungsschnittstellen an das Format des Nutzdatenfeldes der Zelle anzupassen und Steuerinformationen an die Gegenseite zu übermitteln bzw. Steuerinformationen der Gegenseite für die zu verwenden Anpassung (Zeitgenerierung, Rahmenbildung).

Gemäß einem Aspekt der vorliegenden Erfindung sind alle virtuellen Datenpfade unidirektional, d.h. sie beginnen bei einem Initiator und enden bei einem oder mehreren Zielen. Wenn virtuelle Datenpfade logisch zusammengehören, z. HDCP für einen Videokanal, und somit einen bidirektionalen Datenpfad bilden, sollten diese Pfade dieselben VP-Kennungen haben.

Der virtuelle Datenpfad beginnt bei einem Initiator und endet bei einem oder mehreren Zielen. Die Realisierung erfolgt durch die
Zellteilschicht und führt die folgenden Funktionen auf dem virtuellen Pfad aus:
- Multiplexing hinzufügen/ löschen
- VP-Übersetzung

### Stream data (kontinuierlicher Datenstrom)

Die Stream Data-Funktion kombiniert die Zeitdomänenüberquerung und die Bitweite Umwandlung von Daten von der Anwendungsschnittstelle zu den N Bits der Zellenzeilen. Dabei ist die Zellzeilennutzlast bereits so vorformatiert, dass Zell Footer und Header in die erste und letzte Zellzeile passen.

Gestreamte Daten sind (normalerweise) quellensynchron. Hier wird die Zeitdomänenüberquerung (clock domain crossing) des Datenpfads von der Anwendungszeitdomäne zur Zeitschichtdomäne (application clock domain to the Virtual Path Layer clock domain) durchgeführt.

In Senderichtung ist ein Datenpuffer vorgesehen, in den die quellensynchronen Daten mit dem Quellentakt geschrieben werden. Die Segmentierungsschicht ruft die Daten aus diesem Puffer nach Bedarf ab, um die Datenformatumwandlung in die N Bit breiten Reihen der Zellen durchzuführen. Frame-Daten (z. B.: Hsync, Vsync, DE) werden in Payload Info Bits kodiert, sodass auf der Empfängerseite eine Rekonstruktion des Frames möglich ist.

In der Empfangsrichtung werden die Zellendaten von der Reassembly Teilschicht in einen Datenpuffer geschrieben, wobei die Zellenreihen-Bitbreite ist (with cell row bit width). Basierend auf den Payload Info Bits werden die Rahmeninformationen rekonstruiert. Der Quellentakt wird zum Beispiel unter Verwendung von Pufferfüllstand und Taktsynthese regeneriert.

Ist eine Verschlüsselung der Daten erforderlich (HDCP), werden in dieser Funktion die Zelldaten verschlüsselt bzw. entschlüsselt.

Aufgrund der unterschiedlichen Arten von gestreamten Daten, wie z. B.: Audio, Video mit und ohne Verschlüsselung, kann es unterschiedliche Implementierungen dieser Grundfunktion geben (z. B.: VStream In/Out; AStream In/Out; EncVStream In/Out).

Die Schnittstelle zur Segmentierungs- & Reassembly Teilschicht ist für alle Funktionen gleich.

### Burst data (diskontinuierlicher Datenstrom)

Die Burst-Daten-Funktion kombiniert die Zeitdomänenkreuzung und die bitweite Umwandlung (clock domain crossing and data bit wide conversion) von Daten von der Anwendungsschnittstelle zu den N Bits der Zellenzeilen. Dabei ist die Zellzeilennutzlast bereits so vorformatiert, dass Zellfuß und -kopf in die erste und letzte Zellzeile passen.

Burst-Daten sind (normalerweise) synchron zu einer externen Zeit und haben unterschiedliche Kennzeichnungssignale für Richtung und Datentyp (Adresse / Daten / ByteEnable).

Diese Daten werden normalerweise von Steuerleitungen begleitet, um ein bestimmtes Protokoll zu realisieren.

In Senderichtung ist ein Datenpuffer vorgesehen, in den die Burstdaten mit dem Schnittstellentakt geschrieben werden. Die Segmentierungsschicht ruft die Daten aus diesem Puffer nach Bedarf ab, um die Datenformatumwandlung in die N Bit breiten Reihen Zellen durchzuführen.

In der Empfangsrichtung werden die Zellendaten von der Reassembly Teilschicht in einen Datenpuffer geschrieben, wobei die Zellenreihe bitbreit ist. Basierend auf den Payload Info Bits werden die Schnittstellensteuersignale rekonstruiert.

Die Payload-Info-Bits werden verwendet, um die Steuersignale der anwendungsspezifischen Schnittstellen zu erzeugen oder die Protokollzustandsmaschinen in den anwendungsspezifischen Schnittstellen zu synchronisieren.

Aufgrund der unterschiedlichen Schnittstellen, die Burst-ähnliche Daten bereitstellen (SPI, I2C, MII), kann es unterschiedliche Implementierungen dieser Grundfunktion geben (z. B.: SPIBurst, I2CBurst, MIIBurst).

Dementsprechend wird es auch (leicht) unterschiedliche Stream In/Out-Schnittstellen geben, deren Struktur jedoch gleich sein sollte.

Die Aufgabe wird auch gelöst durch eine Systemanordnung in einem Automobil zur Erzeugung einer effizient übertragbaren Bitfolge mit einer eingeschränkten Disparität und einer eingeschränkten Lauflänge, aufweisend eine Schnittstelleneinheit eingerichtet zum Bereitstellen einer beliebigen Bitfolge; eine Segmentierungseinheit eingerichtet zum Segmentieren der bereitgestellten Bitfolge in eine vorab definierte Folge von Segmenten gemäß einer jeweils vorab definierten Bitlänge; eine Berechnungseinheit eingerichtet zum Berechnen einer Vorwärtsfehlerkorrektur für jedes der Segmente oder eine Vielzahl von Segmenten derselben Bitlänge; eine Kodieranordnung eingerichtet zum Kodieren jedes Segments oder einer Vielzahl von Segmenten gleicher Bitposition mitsamt dessen/ deren Vorwärtsfehlerkorrektur in jeweils ein oder mehrere Teilsymbole, unter Verwendung jeweils derselben Kodiereinheit für die Segmente gleicher Bitposition und der zugehörigen Vorwärtsfehlerkorrektur aus einer Mehrzahl von Kodiereinheiten, wobei eine erste Teilmenge von Kodiereinheiten ein Vorzeichen der Disparität des Teilsymbols durch Invertieren der Disparität des erzeugten Teilsymbols zum Ausgleich einer Disparität einer zweiten Teilmenge von Kodiereinheiten aktiv steuert, wobei eine Aneinanderreihung der Teilsymbole die effizient übertragbare Bitfolge mitsamt den berechneten Vorwärtsfehlerkorrekturen ergibt.

Die Aufgabe wird auch gelöst durch ein Computerprogrammprodukt mit Steuerbefehlen, welche das vorgeschlagene Verfahren implementieren beziehungsweise die vorgeschlagene Vorrichtung betreiben.

Erfindungsgemäß ist es besonders vorteilhaft, dass das Verfahren zum Betreiben der vorgeschlagenen Vorrichtungen und Einheiten verwendet werden kann. Ferner eignen sich die vorgeschlagenen Vorrichtungen und Einrichtungen zur Ausführung des erfindungsgemäßen Verfahrens. Somit implementiert jeweils die Vorrichtung strukturelle Merkmale, welche geeignet sind, das entsprechende Verfahren auszuführen. Die strukturellen Merkmale können jedoch auch als Verfahrensschritte ausgestaltet werden. Auch hält das vorgeschlagene Verfahren Schritte zur Umsetzung der Funktion der strukturellen Merkmale bereit. Darüber hinaus können physische Komponenten gleicherweise auch virtuell bzw. virtualisiert bereitgestellt werden.

Weitere Vorteile, Merkmale und Einzelheiten der Erfindung ergeben sich aus der nachfolgenden Beschreibung, in der unter Bezugnahme auf die Zeichnungen Aspekte der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Ebenso können die vorstehend genannten und die hier weiter ausgeführten Merkmale je für sich oder zu mehreren in beliebigen Kombinationen Verwendung finden. Funktionsähnliche oder identische Bauteile oder Komponenten sind teilweise mit gleichen Bezugszeichen versehen. Die in der Beschreibung der Ausführungsbeispiele verwendeten Begriffe "links", "rechts", "oben" und "unten" beziehen sich auf die Zeichnungen in einer Ausrichtung mit normal lesbarer Figurenbezeichnung bzw. normal lesbaren Bezugszeichen. Die gezeigten und beschriebenen Ausführungsformen sind nicht als abschließend zu verstehen, sondern haben beispielhaften Charakter zur Erläuterung der Erfindung. Die detaillierte Beschreibung dient der Information des Fachmanns, daher werden bei der Beschreibung bekannte Schaltungen, Strukturen und Verfahren nicht im Detail gezeigt oder erläutert, um das Verständnis der vorliegenden Beschreibung nicht zu erschweren. In den Figuren zeigen:
- Figur 1:: mehrere Beispiele eines Verfahrensablaufs mit serieller Kodierung und Berechnung einer Vorwärtsfehlerkorrektur gemäß dem Stand der Technik;
- Figur 2:: ein optimierter Verfahrensablauf mit einer Vorwärtsfehlerkorrektur und einer seriellen Kodierung gemäß einem Aspekt der vorliegenden Erfindung;
- Figur 3:: ein Kodieren von Nutzdaten sowie ein Berechnen einer Vorwärtsfehlerkorrektur gemäß dem Stand der Technik;
- Figur 4:: ein Verfahren zur Verbesserung der Vorwärtsfehlerkorrektur bei serieller Kodierung bei einer Datenübertragung im Fahrzeug gemäß der vorliegenden Erfindung;
- Figur 5:: eine Gegenüberstellung der Kodierung gemäß Stand der Technik und dem Verfahren zur Verbesserung der Vorwärtsfehlerkorrektur gemäß einem Aspekt der vorliegenden Erfindung;
- Figur 6:: ein Diagramm, welches die benötigte Anzahl an Gattern je Bitlänge von Vorwärtsfehlerkorrekturen verdeutlicht;
- Figur 7A:: ein Kodieren von Nutzdaten in einen Leitungskode gemäß einem Aspekt der vorliegenden Erfindung;
- Figur 7B:: die vorgeschlagene Systemanordnung zur Verbesserung der Vorwärtsfehlerkorrektur bei serieller Kodierung bei einer Datenübertragung im Fahrzeug gemäß einem Aspekt der vorliegenden Erfindung;
- Figur 8A:: einen Aspekt des Verfahrens zur Verbesserung der Vorwärtsfehlerkorrektur gemäß einem Aspekt der vorliegenden Erfindung auf Senderseite;
- Figur 8B:: ein Verfahren zur Verbesserung der Vorwärtsfehlerkorrektur auf Empfängerseite gemäß am Aspekt der vorliegenden Erfindung;
- Figur 9:: ein Ablaufdiagramm eines Verfahrens zur Verbesserung der Vorwärtsfehlerkorrektur bei serieller Kodierung bei einer Datenübertragung gemäß am Aspekt der vorliegenden Erfindung;
- Figur 10:: ein grundsätzliches Frameformat und die Anwendung eines sogenannten Blockcode gemäß einem Aspekt vorliegenden Erfindung;
- Figur 11:: ein schematisches Diagramm eines Aufbaus und der Struktur des sogenannten Blockcode gemäß einem weiteren Aspekt der vorliegenden Erfindung;
- Figur 12:: ein schematisches Diagramm eines Rahmenformats, wie es erfindungsgemäß Anwendung finden kann; und
- Figuren 13, 14, 15, 16:: beispielhafte Kodierungen von Datensegmenten auf Symbole derart, dass die Disparität gemäß einem Aspekt der vorliegenden Erfindung optimiert ist.

Die vorliegenden Figuren weisen teilweise Parameter auf, welche dem Fachmann in der englischen Bezeichnung so geläufig sind und welche als Parameter verwendet werden und so nicht zu übersetzen sind.

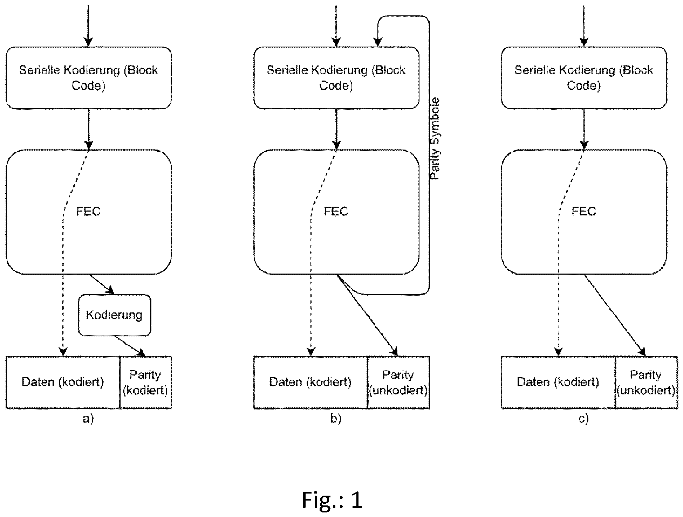

Figur 1 zeigt drei Ausführungsbeispiele, wie gemäß herkömmlicher Verfahren eine Vorwärtsfehlerkorrektur durchgeführt wird. Auf der linken Seite ist ein Ausführungsbeispiel gezeigt, welches zuerst eine serielle Kodierung der Nutzdaten durchführt und sodann einen Vorwärtsfehlerkorrekturcode FEC erzeugt. Die seriell kodierten Daten werden übermittelt und im Nachgang wird die Vorwärtsfehlerkorrektur kodiert und dann an die kodierten Nutzdaten angehängt. Somit wird also gemäß diesem Beispiel aus dem Stand der Technik über ein komplettes Datenwort die Vorwärtsfehlerkorrektur erzeugt und diese muss sodann erneut kodiert werden und wird angehängt. Es wird also nicht über die einzelnen Segmente kodiert, sondern über die Bitfolge im Ganzen.

In der Mitte ist ein weiteres Ausführungsbeispiel aus dem Stand der Technik gezeigt, wobei der Schritt der Leitungskodierung der Vorwärtsfehlerkorrektur ausgelassen wird und eine nicht kodierte Paritätsinformation angehängt wird. Hier entsteht der Nachteil, dass der letzte Datenteil, also die Paritätsinformation nicht leitungskodiert ist und somit stark fehlerbehaftet ist.

Auf der rechten Seite ist ein Beispiel gezeigt, welches im Gegensatz zu dem Ausführungsbeispiel in der Mitte die Rückschleife der Paritätsinformation zur seriellen Kodierung unterlässt. Hierbei ergeben sich die gleichen Nachteile, wie bei dem Beispiel in der Mitte.

Datenübertragungslösungen stellen stets striktere Anforderungen an Fehlerfreiheit/Fehlertoleranz die bei stets steigenden Datenraten eine feine Abstimmung zwischen serieller Kodierung und Forward-Error-Correction (FEC) benötigen.

Der aktuelle Stand der Technik (Ethernet / DisplayPort) verarbeitet den Datenstrom in folgender Reihenfolge:
1. Die Eingangsdaten werden im ersten Schritt mittels serieller Kodierung (8b10b, 64b66b, 128b132b etc.) kodiert. Bei größeren Kodierungen ab 64b66b aufwärts wird dies primär durch Scrambling mittels LFSR erreicht.
2. Der serielle kodierte Strom wird nun mittels FEC (Forward Error Correction) Kodierung zusätzlich vor Bitfehlern geschützt. Eine komplette FEC-Kodierung (FEC-Kodierungs-Wort) beinhaltet sowohl die Eingangsdaten auf Symbolbasis als auch zusätzlich die sogenannten Paritäts-Symbole. Die Eingangsdaten werden für diese Anwendungen durch den FEC unberührt hindurchgereicht. D.h. sie entsprechen stets dem ursprünglichen seriellen Code. Es gibt nun folgende weitere Vorgehensweisen:
   a. Die Parity Symbole werden nun ebenfalls im Nachhinein noch seriell kodiert (z.B. 8b10b) um die Anforderungen für eine serielle Übertragung zu erfüllen (Lauflänge, DC-Balance etc.). Dieses zusätzliche Kodieren der Parity Symbole im Nachhinein benötigt einen weiteren Kodierer in Hardware.
   b. Anstelle der genannten nachträglichen seriellen Kodierung der Parity-Symbole gibt es ebenfalls Lösungen mit Rückkopplung der Parity-Symbole zu Schritt 1.). Bei einem Seriellen-Kodierer besteht die Möglichkeit basierend auf der Wahl eines positiven bzw. negativen Symbols die DC-Balance zu steuern. Dies ist allerdings mit entsprechender Totzeit (in Abhängigkeit der Größen von serieller Kodierung und des FEC-Kodierers) verbunden. Dies kann z.B. betragsmäßig zu einer starken Abweichung der temporären DC-Balancierung führen.
   c. Die Parity Symbole werden unbehandelt direkt auf den seriellen Link gegeben (z.B. DisplayPort 2.0). Dies ist allerdings sehr ungenau da die Paritäts-Symbole in Abhängigkeit der Eingangsdaten entstehen. Man verlässt sich hier darauf, dass die Paritäts-Symbole im Mittel DC-Balanciert sind.

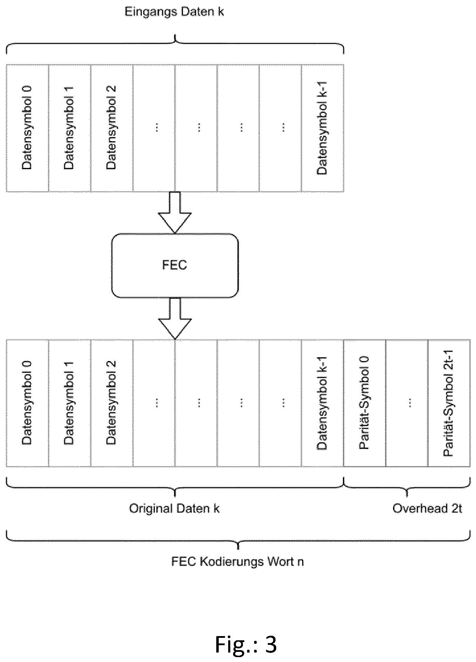

Alle genannten Verfahren (a-c) haben den Nachteil, dass sie einen großen Ressourcenbedarf haben (z.B. zwei serielle Kodierer) oder zu einer ungenügend genauen seriellen Kodierung führen (z.B. DC-Balancierung, Lauflänge, Spektrum). Speziell die ungenaue Kontrolle über die serielle Kodierung kann in Kombination mit dem Übertragungskanal dazu führen, dass empfängerseitig der Datenstrom nicht fehlerfrei rekonstruiert werden kann (CDR sampelt falsch). Diese Effekte werden im Betrieb mit FEC abgeschwächt (da dieser Bit-/Symbolfehler korrigiert), was der FEC-Kodierung unnötigerweise mit jedem Fehler, der durch die schlechte serielle Kodierung entsteht, Korrektur-Marge für weitere nötige Fehlerkorrektur für Fehler, die durch Signalintegrität oder z.B. äußere Einwirkungen entstehen, nimmt. Ein Reed Solomon FEC kann basierend auf der Größe des Overheads (2t siehe Figur 3) in Symbolen nur t Symbolfehler korrigieren.

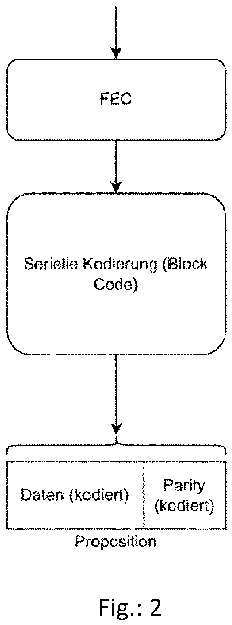

Figur 2 hingegen zeigt das erfindungsgemäße Verfahren, bei dem über die Nutzdaten Vorwärtsfehlerkorrekturen erzeugt werden und diese werden dann ebenfalls mit den Nutzdaten kodiert. Der Vorteil besteht hierin, dass sowohl die Nutzdaten als auch die Vorwärtsfehlerkorrektur leitungskodiert sind und somit Fehler robust sind. Anhand dieser Figur wird ebenfalls ersichtlich, dass der Unterschied zum Stand der Technik darin besteht, dass die Vorwärtsfehlerkorrektur direkt auf den Nutzdaten erzeugt werden und nicht eben auf den leitungskodierten Nutzdaten. Dies ermöglicht es sodann alle Daten leitungskodiert zu übertragen, was wiederum eine erhöhte Fehlerrobustheit mit sich bringt.

Das im Weiteren vorgeschlagene Verfahren zur Verbesserung genannter Problematik gilt für alle denkbaren ECC/FEC Kodierungen und ist nicht nur bei Reed Solomon Codes anwendbar.

Das vorgestellte Verfahren ändert die Reihenfolge von serieller Kodierung und FEC:
1. Die Eingangsdaten werden im ersten Schritt mittels FEC bzw. mehreren individuellen FEC-Einheiten kleinerer Symbolbreite (6-12 Bit) geschützt. Dies führt hier ebenfalls insgesamt zu dem Overhead 2t. Die Verwendung von mehreren FEC-Sub-Kodierungen wird hier ausdrücklich präferiert, da dies weiter positive Eigenschaften mit sich bringt (wird im Folgenden erläutert).
2. Anschließend wird das oder die jeweiligen aktuellen FEC-Ausganssymbole (nicht zu verwechseln mit dem gesamten FEC Kodierungs-Wort n) mittels Block Code so kodiert, dass alle gewünschten Eigenschaften an DC-Balance, Lauflänge, Frequenzspektrum etc. eingehalten werden.
   Im Falle von mehreren FEC-Kodieren im Schritt 1.) wird hier mit exakt derselben Anzahl an Block Kodierern gearbeitet. Dies führt auf der Empfangsseite dazu, dass sich ein Bitfehler auf dem Link, der ein komplettes Datensymbol des seriellen Codes zerstört, zu nur einem einzigen FEC-Symbolfehler führt.

Figur 3 zeigt ein Ablaufdiagramm gemäß dem Stand der Technik, wobei die Eingangsdaten leitungskodiert werden und sodann wird eine Vorwärtsfehlerkorrektur erzeugt. Diese Vorwärtsfehlerkorrektur wird, wie ganz unten eingezeichnet ist, auf der vorliegenden rechten Seite angehängt. Somit wird also zuerst das Datenwort oben leitungskodiert und sodann wird ein nicht leitungskodierter Vorwärtsfehlerkorrektur angehängt. Dies stellt nunmehr ein Problem dar, da die Vorwärtsfehlerkorrektur nicht die gewünschten Eigenschaften aufweist, die zu einer robusten Datenübertragung notwendig sind. Es ergeben sich also dadurch Nachteile, dass die Daten nicht DC (digital current) balanciert sind, also eine vorteilhafte Parität nicht eingestellt ist. Darüber hinaus kann es bei einer nicht leitungskodierten Übertragung Fehler bei der Taktwiederherstellung geben. Generell ist eine Leitungskodierung dahingehend vorteilhaft, dass ein Mittelwert derjenigen analogen Signale gemessen werden kann und sodann kann geprüft werden, welche tatsächlichen Signale sich über diesem Mittelwert befinden und welche darunter. Hierbei ist es wünschenswert, dass die Anzahl der analogen Signale über dem Mittelwert, also digitale "1", gleich der Anzahl der analogen Signale unter dem Mittelwert, also digitale "0", entspricht. Somit kann eine optimierte Signalmodellierung durchgeführt werden. Dies ist in der vorliegenden Figur 3 nicht möglich, da der Vorwärtsfehlerkorrekturkode nicht leitungskodiert wird.

Figur 4 zeigt das erfindungsgemäße Vorgehen und das Übertragen über einen verlustbehafteten Kanal. Hierbei ist jeder Kanal potenziell Verlust behaftet und es ist besonders vorteilhaft, dass bei dem Dateneingang zuerst die Vorwärtsfehlerkodierung erfolgt und sodann die gesamte serielle Kodierung erfolgt. Auf Empfängerseite wird das Verfahren analog invers ausgeführt und es erfolgt zuerst eine serielle Dekodierung, wodurch neben den Nutzdaten auch die Vorwärtsfehlerkorrektur wiederhergestellt wird.

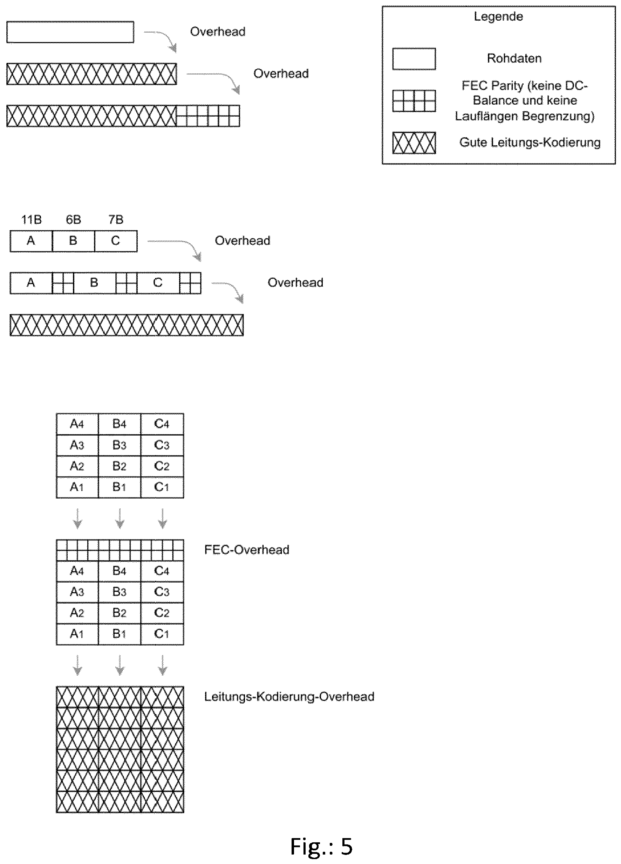

Figur 5 zeigt in einem oberen Ausführungsbeispiel ein Verfahren gemäß dem Stand der Technik, wobei in einem ersten Verfahrensschritt von der ersten auf die zweite Zeile ein Ausgangsdatenwort bzw. eine Bitfolge leitungskodiert wird. Hieraus entsteht ein Kode der länger ist als die Ausgangsbitfolge, was vorliegend als auch Overhead bezeichnet wird. In einem darauffolgenden Verfahrensschritte wird von der zweiten Zeile auf die dritte Zeile ein Vorwärtsfehlerkorrekturkode erzeugt, der der Leitungskodierung angefügt wird. Wie nunmehr ersichtlich ist, ist der erste Teil links der zu übertragenen Daten leitungskodiert und der zweite Teil, nämlich die Vorwärtsfehlerkorrektur ist nicht leitungskodiert. Dies bringt Probleme mit sich, da auf die Vorteile der Leitungskodierung bei dem Anhang auf der rechten Seite verzichtet werden muss. Dies ist nachteilig.

In dem Ausführungsbeispiel in der Mitte der vorliegenden Figur ist oben wieder das Ausgangswort ABC eingezeichnet. Die Bitfolge besteht also aus den Segmenten A, B und C. Diese sind vorliegend 11 Bit, 6 Bit und 7 Bit lang. Erfindungsgemäß wird jetzt eben nicht das gesamte Datenwort also die gesamte Bitfolge in ihrer Gesamtheit geschützt, d.h. mit einem Vorwärtsfehlerkorrekturcode versehen, sondern es werden die einzelnen Segmente geschützt. Dies ist in der zweiten Zeile dadurch eingezeichnet, dass nach jedem Segment A, B und C der entsprechende Vorwärtsfehlerkorrekturcode eingezeichnet ist. In einem darauffolgenden Verfahrensschritt wird in der dritten Zeile eine Leitungskodierung angewendet bzw. die Daten aus der zweiten Zeile werden komplett leitungskodiert, was zu einem Leitungskode in der dritten Zeile führt. Dieser kann nunmehr übertragen werden und es ist ersichtlich, dass die gesamten Daten leitungskodiert sind und eben auch der Vorwärtsfehlerkorrekturkode leitungskodiert ist. Somit finden die Vorteile der Leitungskodierung auf sämtliche zu übertragenen Daten Anwendung.

In dem Ausführungsbeispiel ganz unten in Figur 5 sind die erfindungsgemäßen Verfahrensschritte gezeigt, wobei weitere Unterschritte möglich sind. Es sind die unterschiedlichen Bitfolgen eingezeichnet, wobei nunmehr die Nutzdaten in Bitfolgen gleicher Länge unterteilt wurden. Somit wird die Gesamtheit der Nutzdaten in vorliegend vier Bitfolgen unterteilt, welche alle gleicher Länge sind. Diese vorliegend vier Bitfolgen werden wiederum in Segmente gleicher Länge unterteilt. Bildlich gesprochen sind also horizontal einzelne Bitfolgen angeordnet und diese Bitfolgen sind bildlich gesprochen untereinander angeordnet, sodass jede Zeile eine Bitfolge widerspiegelt. Wie ebenfalls ersichtlich ist, sind die Bitfolgen jeweils in drei Segmente gleicher Länge unterteilt. Dies gibt eine matrixartige Anordnung der Nutzdaten in Bitfolgen je Zeile und Segmente je Spalte.

Nunmehr wird eben nicht, wie es im Stand der Technik vorgesehen ist, eine Leitungskodierung durchgeführt, sondern es wird gemäß der Unterteilungsvorschrift, wie sie im oberen Verfahrensschritt vorgegeben ist, je Spalte, d.h. also für alle Segmente an gleicher Bitposition eine Teilvorwärtsfehlerkorrektur errechnet. Wie in der ersten Zeile des zweiten Rechtecks zu sehen ist, ist oben eine Teilvorwärtsfehlerkorrektur eingezeichnet, welche in der vorliegenden Figur in ihrer Gesamtheit als FEC Overhead bezeichnet wird. Nunmehr liegen also die segmentierten Bitfolgen gemäß der Unterteilungsvorschrift vor und es liegen die Teilvorwärtsfehlerkorrekturen für alle Segmente gleicher Bitposition über alle Bitfolgen vor.

Nunmehr erfolgt ein Anwenden jeweils eines Segmentkodierers über jeweils alle Segmente gleicher Bitposition zur Erzeugung von Segmentleitungskodes über alle Segmente je Bitposition und je Bitfolge. In einem weiteren oder in dem gleichen Verfahrensschritt erfolgt ein Anwenden jeweils desjenigen Segmentkodierers auf die jeweilige Teilvorwärtsfehlerkorrektur, der auch für die Segmente angewendet wurde und es ergibt sich somit ein einziger Leitungskode, welcher die Segmentleitungskodes umfasst und die Teilvorwärtsfehlerkorrekturleitungskodes. Wie nunmehr unten in der vorliegenden Figur 5 ersichtlich ist, wurden also alle Daten leitungskodiert und insbesondere wurde auch die Vorwärtsfehlerkorrektur FEC leitungskodiert. Somit können diese Daten nunmehr vorteilhaft übertragen werden.

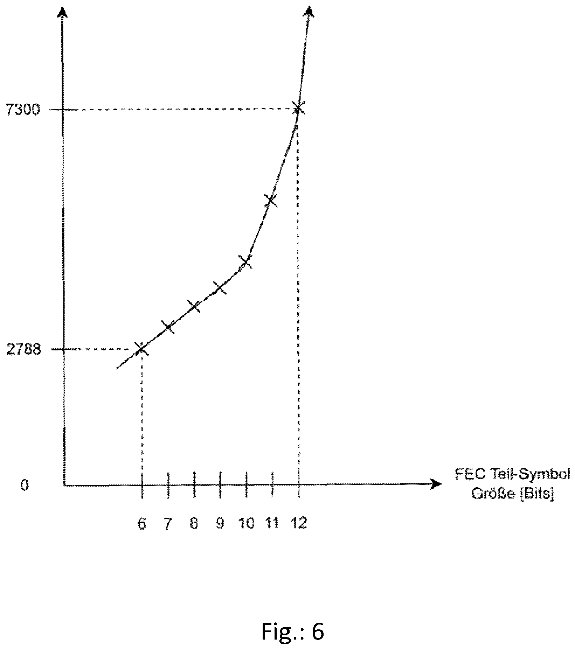

Figur 6 zeigt in einem Diagramm auf der y-Achse die Anzahl der benötigten Gatter bei der Erstellung eines Vorwärtsfehlerkorrekturkodes in Abhängigkeit der zu kodierenden Bitlänge auf der x-Achse. Wie vorliegend ersichtlich ist, handelt es sich hierbei um ein exponentielles Wachstum und ab einer Bitlänge von 10-12 Bit steigt das Wachstum der Gatter, also die Anzahl der benötigten Gatter für die Vorwärtsfehlerkorrekturen, überdurchschnittlich. Somit ist es erfindungsgemäß besonders vorteilhaft die Vorwärtsfehlerkorrektur je Segment auszuführen, da hierdurch vermieden wird, dass das gesamte Datenwort, also die gesamte Bitlänge berücksichtigt werden muss. Würde die gesamte Bitlänge bei der Vorwärtsfehlerkorrektur berücksichtigt werden müssen, so wäre die Bitlänge typischerweise jenseits der kritischen 12 Bit. Die benötigten Gatter in den Vorwärtsfehlerkorrekturkodierer würden in unvorteilhafter Weise ansteigen. Dies verdeutlicht also den vorteilhaften technischen Effekt der vorliegenden Erfindung, die zuerst Segmente über die Bitfolge gebildet und sodann auf den Segmenten die Vorwärtsfehlerkorrektur berechnet.

An dieser Stelle wird nochmals auf die Unterteilungsvorschrift gemäß Figur 5 abgestellt, welche vorsieht, dass ein Segment 11 Bit, 6 Bit oder 7 Bit aufweisen kann.

Durch die Verwendung mehrerer und dadurch von der FEC-Symbolgröße kleinerer FEC-Kodierer/ Dekodierer wird sowohl die Anzahl benötigter Gatter kleiner als auch die maximale Betriebsfrequenz bei gegebenem Prozessknoten Fₘₐₓ größer (kürzere Carry Chains, mehr Parallelität).

In Figur 6 kann der Zusammenhang zwischen der FEC Symbol-Größe in Bits und der benötigten Implementierung gesehen werden. Dies bezieht sich auf eine Hardwareimplementierung eines Reed Solomon FECs. Die Gatter Anzahl ist normalisiert (auf 12 Bit Symbolgröße) es kann somit direkt verglichen werden. Der exponentiell ausgeprägte Zusammenhang zwischen Symbolgröße in Bits und der Implementierung in Gattern kann dem Graphen entnommen werden.

Für die jeweiligen kleinen FEC-Sub-Kodierer müssen hier keineswegs stets die gleichen Symbolbreiten verwendet werden. Große serielle Kodierungen können hier, wie mit der Verwendung für FEC vorgeschlagen, ebenfalls aus mehreren unterschiedlichen Sub-Kodieren (einfachstes Beispiel 8b10b das aus 3b4b und 5b6b aufgebaut werden kann) bestehen. Im Falle der vorliegenden Erfindung bzw. ADXpress (eingetragene Marke) wir dies durch insgesamt 11 Kodierer mit vier Grundtypen: 6b8b, 7b8b, 11 b12b und 11 b13b erreicht. Die für die jeweilige Sub-Kodierung verwendete FEC-Symbolbreite ergibt sich durch die Datenwortbreite des jeweiligen seriellen Kodierers. Für z.B. 6b8b wird entsprechend ein FEC mit Symbolbreite 6 Bit verwendet.

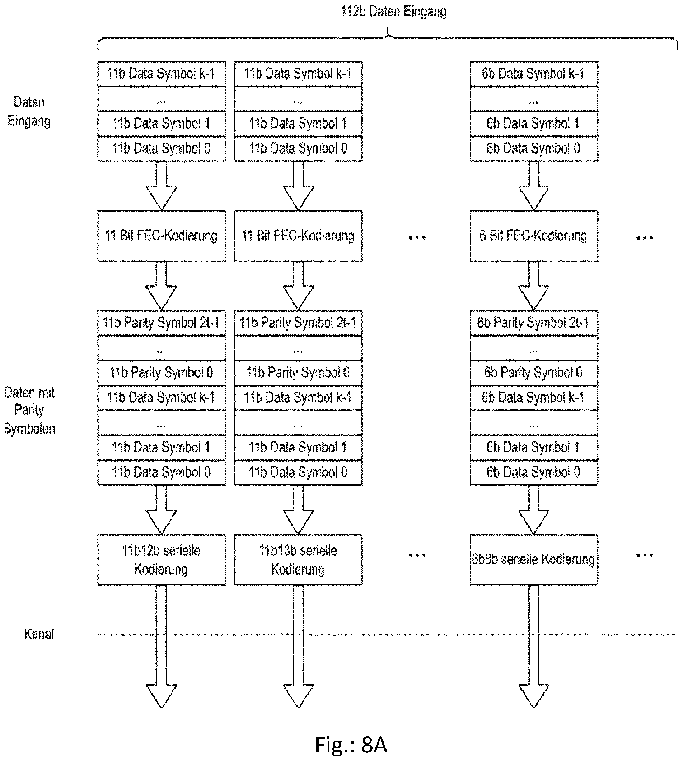

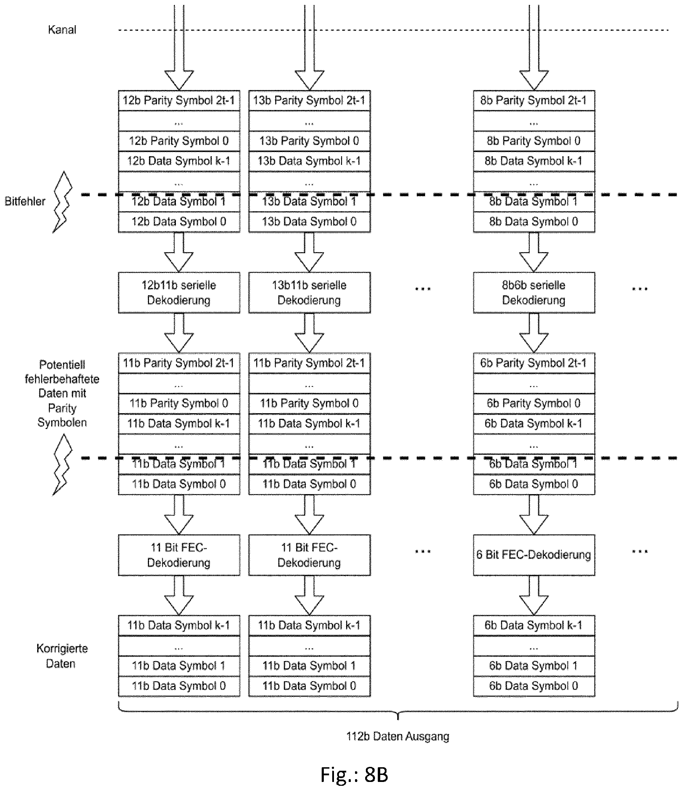

Der komplette Aufbau für den Senderdatenpfad der vorliegenden Erfindung bzw. ADXpress (eingetragene Marke) ist gemäß einem Aspekt in Abbildung 8A dargestellt. Der Datenpfad im Empfänger ist entsprechend invers aufgebaut (siehe auch Figur 8B).

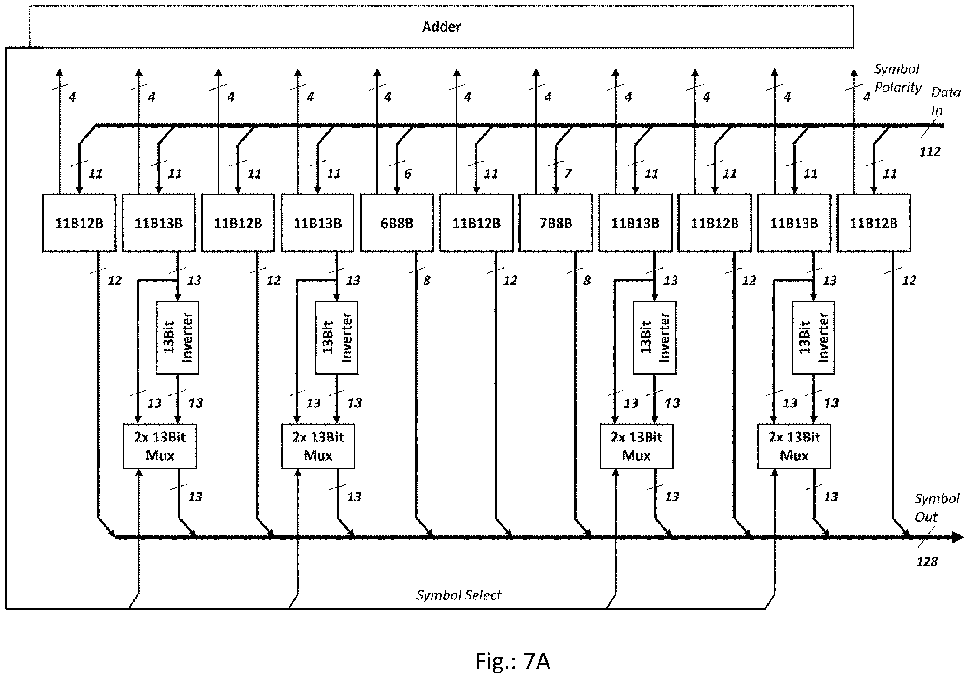

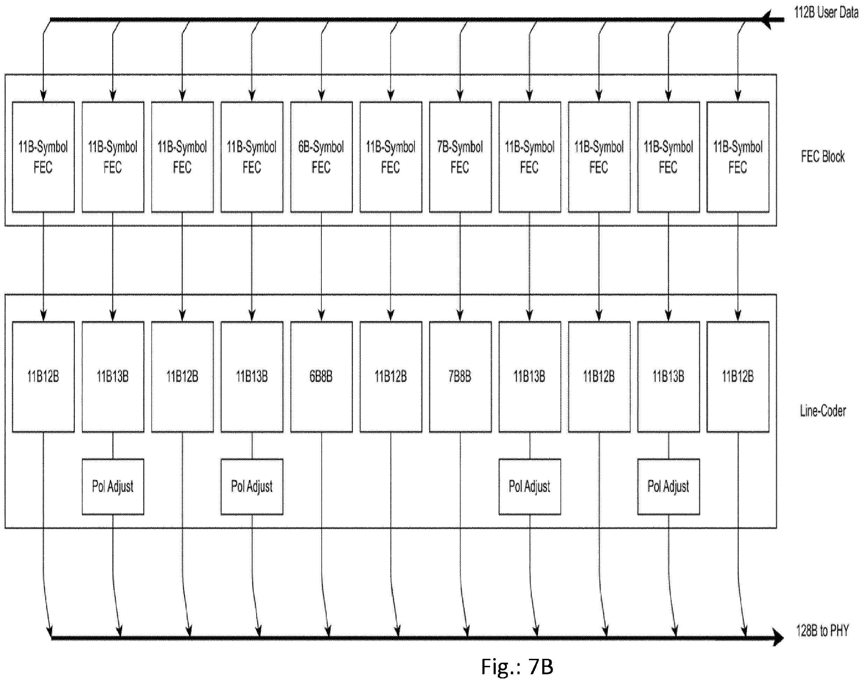

Figur 7A zeigt einen Leitungskodierung bzw. eine Leitungskodierungsvorrichtung mit mehreren Leitungskodierungseinheiten, welche beispielsweise 11 Bit auf 12 Bit abbilden, 11 Bit auf 13 Bit abbilden, oder 11 Bit auf 12 Bit abbilden. Dies entspricht der Reihenfolge in der vorliegenden Figur 7 rechts nach links und verdeutlicht, dass das Eingangsdatenwort, also die Bitfolge oben in einzelne Segmente unterteilt wird und sodann werden die einzelnen Segmente leitungskodiert. Die Berechnung der Vorwärtsfehlerkorrektur ist in der vorliegenden Figur 7A noch nicht berücksichtigt, so dass die Systemanordnung gemäß Figur 7A als Ausgangssystemanordnung für die vorliegende Erfindung dienen kann.

Figur 7A zeigt oben, die beliebige Bitfolge von 112 Bit, welche segmentiert wird, in 11,6 oder 7 Bit. Sodann werden parallel die Kodiereinheiten angesprochen, welche die Bits derart in Teilsymbole überführen, dass diese bezüglich der Disparität optimiert sind. Zum Beispiel werden 11 Bit nach 12 Bit kodiert bzw. 11 Bit nach 13 Bit.

In der vorliegenden Figur 7A ist auf der ganz linken Seite in der Mitte eine Kodiereinheit aus der zweiten Teilmenge eingezeichnet, welche die Bezeichnung 11 B12B trägt. Diese liefert ein Teilsymbol mit einem beliebigen Vorzeichen, d. h. also mit einer beliebigen Disparität. Um diese Disparität auszugleichen ist die kodierte Einheit 11B13B parallel bezüglich der Bitfolge nachgeschaltet. D. h. also, dass ein Datenstrom gebildet wird, der die höherwertigsten Bits von zweimal 11 in zwei Teilsymbole überführt, nämlich einmal wird durch 11 B12B das 11 Bit Datensegment in ein 12 Bit Teilsymbol mit beliebigen Vorzeichen, also Disparität, gebildet und einmal wird das Datensegment von 11 Bit in 13 Bit mittels der Kodiereinheit 11 B13B kodiert. In der vorliegenden Figur unterhalb der Kodiereinheiten eingezeichnet ist, handelt es sich bei der zweiten Kodiereinheit von links 11B13B um eine Kodiereinheit der ersten Teilmenge. Diese weist einen Inverter und einen Multiplexer auf. Die ersten 13 Bit liegen also als Datenstrom vor, der derart aufgeteilt wird, dass er einmal bezüglich des Vorzeichens, also der Disparität invertiert wird und einmal unverändert bleibt. Weiter unten angezeichnet ist, dass unter Rückkopplung der Disparität derjenige positive oder negative, d. h. der ursprüngliche oder invertierte Datenstrom verwendet wird, der das Vorzeichen aus der ganz linken Kodiereinheit ausgleicht. An dem ersten Multiplexer links liegen also zwei Datenströme an, welche jeweils das Teilsymbol darstellen, einmal mit herkömmlichem Vorzeichen, wie es also aus der Kodiereinheit 11 Bit 13 Bit ausgegeben wird und einmal mit invertierten Vorzeichen bzw. invertierter Disparität.

Aufgrund der Rückkopplung von der Einheit vorliegend ganz oben wird also festgestellt, welche Disparität aus dem ganz linken Kodierer 11B12B resultiert und somit schafft der Multiplexer, vorliegend ganz links unten, einen Ausgleich bzw. eine Minimierung der Disparität des Teilsymbols des ganz linken Kodierers 11B12B. Dies wird parallel derart durchgeführt, dass den Kodiereinheiten aus der zweiten Teilmenge Kodiereinheiten aus der ersten Teilmenge nachgeschaltet werden, welche die Disparität minimieren bzw. eliminieren. Letztendlich wird ganz rechts unten das Gesamtsymbol ausgegeben. Dieses Gesamtsymbol weist 128 Bit auf und ist aus den Teilsymbolen zusammengesetzt, wie sie mittels der geschrägten Pfeile in die fette Linie unten eingefügt werden. Somit liegen also an dieser Ausgabeleitung die Teilsymbole an, welche bezüglich der Disparität optimiert bzw. minimiert sind und diese Teilsymbole Formen das gesamte Symbol, welches sodann ausgegeben und übertragen werden kann.

Die Erfindung kodiert gemäß einem Aspekt der vorliegenden Erfindung ein 112 Bit breites Datenwort, mit beliebiger Disparität (Disparität max: 112) und beliebiger Lauflänge (Lauflänge max: 112), auf ein 128 Bit breites Symbol. Damit beträgt der durch die Kodierung entstehende Overhead 14.2%.

Die maximal in dem Symbol, wie auch bei beliebiger Sequenzierung beliebiger Symbole auftretende Lauflänge beträgt 8 gleiche Bits.

Die maximale Disparität im langen Mittel ist 0. Die Disparität in einem Symbol ist kleiner 9.

Dabei ist die Komplexität der Logik minimal, vergleichbar mit 10 8B/10B Kodierern (mit dem bekannten Nachteil des großen Overheads).

Erreicht wird dies durch den Einsatz, bzw. die parallele Verwendung von mehreren "kleinen" in ihrer Charakteristik bei Disparität und Lauflänge optimal aufeinander abgestimmten Kodierern.

Die Kodierer 11B12B, 7B8B und 6B8B erzeugen alle Symbole mit einer garantierten maximalen Lauflänge von 6, auch bei beliebiger Sequenzierung der (Teil)Symbole.

Der Kodierer (11B13B) erzeugt gemäß einem Aspekt der vorliegenden Erfindung Symbole mit einer garantierten maximalen Lauflänge von 7 bzw. am Anfang oder Ende des Symbols von 5. Auf Grund der Sequenzierung (Abb2) der (11B13B) mit den anderen Codierern kann so maximal eine Lauflänge von 8 im Symbol entstehen.

Siehe Eigenschaften der Kodierer, wie folgt:
- 11B13B: 11 Bit Daten werden auf 2048 Symbole mit 13 Bit abgebildet. Die Symbole können invertiert oder nicht invertiert übertragen werden.
   Disparität:
   +3... +9 oder steuerbar -3...-9
   Lauflänge im Wort: 7
   Lauflänge am Rand: 5.
- 11B13B: 11 Bit Daten werden auf 2048 Symbole mit 13 Bit abgebildet. Die Symbole können invertiert oder nicht invertiert übertragen werden.
   Disparität: +3... +9 oder steuerbar -3...-9
   Lauflänge im Wort: 7
   Lauflänge am Rand: 5
- 11B12B: 11 Bit Daten werden auf 2048 Symbole mit 12 Bit abgebildet. Die Symbole werden nur nicht invertiert übertragen.
   Disparität: -2, -1, 0, 1, 2
   Lauflänge im Wort: 6
   Lauflänge am Rand: 3
- 7B8B: 7 Bit Daten werden auf 128 Symbole mit 8 Bit abgebildet. Die Symbole werden nur nicht invertiert übertragen.
   Disparität: -2, -1, 0, 1, 2
   Lauflänge im Wort: 6
   Lauflänge am Rand: 3
- 6B8B: 6 Bit Daten werden auf 64 Symbole mit 8 Bit abgebildet. Die Symbole werden nur nicht invertiert übertragen.
   Disparität: 0
   Lauflänge im Wort: 6
   Lauflänge am Rand: 3

Mit den vier 11B13B Kodierern kann steuerbar eine Disparität von mindestens +-12 erzeugt werden, um die nicht steuerbare Disparität von maximal +-12 (6 x +-2) der Kodierer 11B12B und 7B8B auszugleichen, so dass unabhängig von den zu übertragenden Daten eine ausgeglichene Disparität sicher erreicht werden kann.

Um die Komplexität der Hardware weiter zu reduzieren, werden gemäß einem Aspekt der vorliegenden Erfindung vier kleine Kodierer (11B13B) verwendet, deren Disparität sich hinsichtlich Vorzeichen (+-) steuern lässt.

Die Steuerung der Symbol-Disparität erfolgt gemäß einem Aspekt der vorliegenden Erfindung derart, dass jeder Kodierer die Parität "seines" Teilsymbols berechnet. Dies geschieht mit wenig Aufwand, da das Teilsymbol nur wenige Bits aufweist.

Bei vier der elf Kodierern kann das Vorzeichen der Disparität des Teilsymbols durch die Invertierung des erzeugten Teilsymbols aktiv gesteuert werden. Dazu weisen die Kodierer (11B13B) die Besonderheit auf, dass deren Symbole für alle Eingangsdaten ein Symbol mit positiver Disparität (+3... +9) erzeugen. Durch Invertierung des Teilsymbols erhält man ein Symbol mit negativer Disparität (-3...-9).

So kann die Disparität (-2,-1,0,1,2) der Teilsymbole der anderen Kodierer (11B12B und 7B8B) kompensiert werden. Der Kodierer 6B8B erzeugt Symbole deren Disparität immer 0 ist. Dann werden alle (Teil) Paritäten der Kodierer (11B12B und 7B8B) addiert und das Ergebnis steuert die Entscheidung, wie viele invertierte und nicht-invertierte Symbole der Kodierer (11B13B) verwendet werden.

Dabei beträgt die mindeste (kleinste) Disparität des Kodierers 11B13B +-3. Also in Summe kann mit diesen vier Kodierern sicher eine Disparität von +-12 (4*+-3) pro Symbol kompensiert werden.

Weiter werden fünf (11B12B) Kodierer und ein (7B8B) Kodierer verwendet deren maximale Disparität +-2 beträgt. Also im Extremfall erzeugen diese sechs Kodierer genau eine Disparität von +-12 (2*+-6). Diese kann sicher durch die 11B13B Kodierer kompensiert werden.

Das Verfahren erreicht gemäß einem Aspekt der vorliegenden Erfindung dieselbe Qualität wie ein 8B10B Code aber mit der Hälfte des Overheads (Verlust durch die Kodierung).

Die Implementierung der Kodier- und Dekodier- Hardware braucht nur minimale Ressourcen (Logik) auf Grund der Verwendung von mehreren kleinen Kodierern anstelle eines Großen.

Die Kodierung kann typischerweise komplett in einem Takt des parallelen Datenpfades erfolgen (kein Pipelining notwendig).

Die Steuerung der Disparität des 128 Bit Symbols kann mit (sehr) wenig Logik realisiert werden, und kann vollständig innerhalb eines Taktes des Datenpfades (langsam) realisiert werden, anstelle einer Berechnung der Disparität durch Zählen der eins und null Bits im seriellen Datenstrom mit dem sehr schnellen seriellen Takt.

Aufgrund der deterministischen Disparität und Lauflänge (Run Length) ist ein weiteres Scrambling nicht notwendig und damit ein schnelles Synchronisieren auf den Datenstrom Empfänger seitig möglich (keine Scramblersynchronisation nötig).

Dies ist unter anderem sehr nützlich für Power-Save-Modi in denen der Link zu Energiesparzwecken abgeschaltet und bei Bedarf wieder eingeschaltet werden kann. Hierfür ist eine schnelle Synchronisation zwischen Sender und Empfänger ein Muss.

Die Erfindung kodiert gemäß einem Aspekt der vorliegenden Erfindung ein 112 Bit breites Datenwort, mit beliebiger Disparität (Disparität max: 112) und beliebiger Lauflänge (Lauflänge max: 112), auf ein 128 Bit breites Symbol. Damit beträgt der durch die Kodierung entstehende Overhead 14.2%.

Die maximal in dem Symbol, wie auch bei beliebiger Sequenzierung beliebiger Symbole auftretende Lauflänge beträgt 8 gleiche Bits.

Die maximale Disparität im langen Mittel ist 0. Die Disparität in einem Symbol ist kleiner 9.

Dabei ist die Komplexität der Logik minimal, vergleichbar mit 10 8B/10B Kodierern (mit dem bekannten Nachteil des großen Overheads).

Erreicht wird dies durch den Einsatz, bzw. die parallele Verwendung von mehreren "kleinen" in ihrer Charakteristik bei Disparität und Lauflänge optimal aufeinander abgestimmten Kodierern.

Die Kodierer 11B12B, 7B8B und 6B8B erzeugen alle Symbole mit einer garantierten maximalen Lauflänge von 6, auch bei beliebiger Sequenzierung der (Teil)Symbole.

Der Kodierer (11B13B) erzeugt gemäß einem Aspekt der vorliegenden Erfindung Symbole mit einer garantierten maximalen Lauflänge von 7 bzw. am Anfang oder Ende des Symbols von 5. Auf Grund der Sequenzierung (Abb2) der (11B13B) mit den anderen Kodierern kann so maximal eine Lauflänge von 8 im Symbol entstehen.

Siehe Eigenschaften der Kodierer wie folgt:
Um die Komplexität der Hardware weiter zu reduzieren, werden vier kleine Kodierer (11B13B) verwendet, deren Disparität sich hinsichtlich Vorzeichen (+-) steuern lässt.

Die Steuerung der Symbol-Disparität erfolgt gemäß einem Aspekt der vorliegenden Erfindung derart, dass jeder Kodierer die Parität "seines" Teilsymbols berechnet. Dies geschieht mit wenig Aufwand, da das Teilsymbol nur wenige Bits aufweist.

Bei vier der elf Kodierern kann das Vorzeichen der Disparität des Teilsymbols durch die Invertierung des erzeugten Teilsymbols aktiv gesteuert werden. Dazu weisen die Kodierer (11B13B) die Besonderheit auf, dass deren Symbole für alle Eingangsdaten ein Symbol mit positiver Disparität (+3... +9) erzeugen. Durch Invertierung des Teilsymbols erhält man ein Symbol mit negativer Disparität (-3...-9).

So kann die Disparität (-2,-1,0,1,2) der Teilsymbole der anderen Kodierer (11B12B und 7B8B) kompensiert werden. Der Kodierer 6B8B erzeugt Symbole deren Disparität immer 0 ist. Dann werden alle (Teil) Paritäten der Kodierer (11B12B und 7B8B) addiert und das Ergebnis steuert die Entscheidung, wie viele invertierte und nicht-invertierte Symbole der Kodierer (11B13B) verwendet werden.

Dabei beträgt die mindeste (kleinste) Disparität des Kodierers 11B13B +-3. Also in Summe kann mit diesen vier Kodierern sicher eine Disparität von +-12 (4*+-3) pro Symbol kompensiert werden.

Weiter werden fünf (11B12B) Kodierer und ein (7B8B) Kodierer verwendet deren maximale Disparität +-2 beträgt. Also im Extremfall erzeugen diese sechs Kodierer genau eine Disparität von +-12 (2*+-6). Diese kann sicher durch die 11B13B Kodierer kompensiert werden.

Das Verfahren erreicht dieselbe Qualität wie ein 8B10B Code aber mit der Hälfte des Overheads (Verlust durch die Kodierung).

Die Implementierung der Kodier- und Dekodier- Hardware braucht nur minimale Ressourcen (Logik) auf Grund der Verwendung von mehreren kleinen Kodierern anstelle eines Großen.

Die Kodierung kann typischerweise komplett in einem Takt des parallelen Datenpfades erfolgen (kein Pipelining notwendig).

Die Steuerung der Disparität des 128 Bit Symbols kann mit (sehr) wenig Logik realisiert werden, und kann vollständig innerhalb eines Taktes des Datenpfades (langsam) realisiert werden, anstelle einer Berechnung der Disparität durch Zählen der eins und null Bits im seriellen Datenstrom mit dem sehr schnellen seriellen Takt.

Aufgrund der deterministischen Disparität und Lauflänge (Run Length) ist ein weiteres Scrambling nicht notwendig und damit ein schnelles Synchronisieren auf den Datenstrom empfängerseitig möglich (keine Scramblersynchronisation nötig).

Dies ist unter anderem sehr nützlich für Power-Save-Modi in denen der Link zu Energiesparzwecken abgeschaltet und bei Bedarf wieder eingeschaltet werden kann. Hierfür ist eine schnelle Synchronisation zwischen Sender und Empfänger ein Muss.

Figur 7B zeigt nunmehr die angepasste Systemanordnung aus Figur 7A, wobei nun entsprechende Teilvorwärtsfehlerkorrekturkodierer eingezeichnet sind. Diese werden vorliegend als FEC Block bezeichnet. Aus dieser Figur wird also ersichtlich, dass aus den Bitfolgen zuerst Segmente gebildet werden, was den oberen Pfeilen entspricht, die von den Nutzdaten abwärts gerichtet sind. Hier werden also die Teilvorwärtsfehlerkorrekturen erzeugt und sodann in die Kodiereinheiten eingespeist, wie diese bereits in Figur 7A ersichtlich sind. Die Leitungskodiereinheiten werden vorliegend als Line Coder bezeichnet und kodieren sowohl die Segmente der Bitfolgen als auch die Teilvorwärtsfehlerkorrekturen. In optionalen Verfahrensschritten kann noch die Parität justiert werden. Unten werden sodann die leitungskodierten Daten ausgegeben und nach rechts über einen potenziell fehlerbehafteten Kommunikationskanal an einen Empfänger, vorliegend nicht eingezeichnet, übersendet.

Figur 8A zeigt das erfindungsgemäße Verfahren zur Verbesserung der Vorwärtsfehlerkorrektur und zeigt insbesondere die Verfahrensschritte, welche senderseitig durchgeführt werden. Die Pfeile unten in der vorliegenden Figur 8A entsprechen dem Pfeil oben in der darauffolgenden Figur 8B. Die Daten werden also gemäß Figur 8A eingegeben und sodann erfolgt das Berechnen der Teilvorwärtsfehlerkorrektur. Wie oben ersichtlich ist, sind alle Segmente gleicher Bitlänge. D.h. also, dass die erste Spalte 11 Bit umfasst, die zweite Spalte 11 Bit umfasst und die letzte Spalte 6 Bit umfasst.

Über alle Segmente gleicher Bitfolge wird nunmehr eine Teilvorwärtsfehlerkorrektur erzeugt, die die gleiche Bitlänge hat, wie die entsprechenden Segmente. Hieraus ergeben sich die Daten mit einem Paritätssymbol. In einem abschließenden Verfahrensschritt erfolgt die serielle Leitungskodierung, welche beispielsweise 11 Bit auf 12 Bit abbildet oder 11 Bit auf 13 Bit abbildet oder 6 Bit auf 8 Bit abbildet. Diese Daten können nunmehr über den potenziell störungsanfälligen Kanal übertragen werden. Dies führt zu einer Übertragung wie sie in der Figur 8A unten eingezeichnet ist oder aber in der vorliegenden Figur 8B oben eingezeichnet ist.

Figur 8B zeigt das Verfahren auf Empfängerseite und entspricht dem Verfahren aus Figur 8A invers. Wie zusätzlich in der vorliegenden Figur 8B eingezeichnet ist, wird erkannt, dass Bit Fehler vorliegen können, die jedoch auf Segmentebene besonders vorteilhaft behandelt werden können. Die Bitfehler entstehen also nicht in der gesamten Bitfolge, sondern lediglich auf einzelnen Segmenten und können daher vorteilhaft behandelt werden. Dies führt zu den korrigierten Daten, wie sie in der Figur 8B unten eingezeichnet sind und es werden somit die 112 Bit zurückgewonnen, wie sie in der Figur 8A als Ausgang gedient haben.

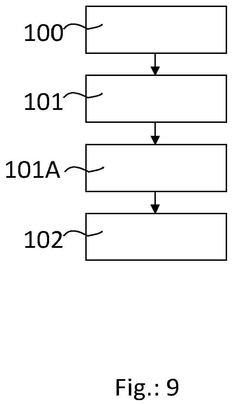

Figur 9 zeigt in einem Ablaufdiagramm ein Verfahren in einem Automobil zum Erzeugen einer effizient übertragbaren Bitfolge mit einer eingeschränkten Disparität, einer eingeschränkten Lauflänge und einer leitungskodierten Vorwärtsfehlerkorrektur, aufweisend ein Bereitstellen 100 einer beliebigen Bitfolge; ein Segmentieren 101 der bereitgestellten Bitfolge in eine vorab definierte Folge von Segmenten gemäß einer jeweils vorab definierten Bitlänge; ein Berechnen 101A einer Vorwärtsfehlerkorrektur für jedes der Segmente oder eine Vielzahl von Segmenten derselben Bitlänge; ein Kodieren 102 jedes Segments oder einer Vielzahl von Segmenten gleicher Bitposition mitsamt dessen/ deren Vorwärtsfehlerkorrektur in jeweils ein oder mehrere Teilsymbole, unter Verwendung jeweils derselben Kodiereinheit für die Segmente gleicher Bitposition und der zugehörigen Vorwärtsfehlerkorrektur aus einer Mehrzahl von Kodiereinheiten, wobei eine erste Teilmenge von Kodiereinheiten ein Vorzeichen der Disparität des Teilsymbols durch Invertieren der Disparität des erzeugten Teilsymbols zum Ausgleich einer Disparität einer zweiten Teilmenge von Kodiereinheiten aktiv steuert, wobei eine Aneinanderreihung der Teilsymbole die effizient übertragbare Bitfolge mitsamt den berechneten Vorwärtsfehlerkorrekturen ergibt.

Es erfolgt zudem ein Übertragen aller Segmentleitungskodes und aller Teilvorwärtsfehlerkorrekturleitungskodes: In diesem letzten Schritt werden alle erzeugten Segmentleitungskodes und Teilvorwärtsfehlerkorrekturleitungskodes übertragen. Diese übertragenen Codes enthalten die Informationen zur Fehlererkennung und -korrektur für die entsprechenden Segmente und Teilvorwärtsfehlerkorrekturen. Das beschriebene Verfahren ermöglicht eine verbesserte Vorwärtsfehlerkorrektur bei der seriellen Kodierung und Datenübertragung im Fahrzeug. Durch das Aufteilen der Nutzdaten in Segmente und die Anwendung spezifischer Kodierverfahren auf diese Segmente wird eine effektive Fehlererkennung und -korrektur auf Segmentebene erreicht.

Durch die iterative Erstellung einer Teilvorwärtsfehlerkorrektur für alle Segmente gleicher Bitposition und die Anwendung eines Segmentkodierers auf jedes Segment wird eine gezielte Fehlerkorrektur für die übertragenen Daten ermöglicht. Die Teilvorwärtsfehlerkorrekturleitungskodes enthalten die notwendigen Informationen, um Fehler zu erkennen und zu korrigieren, während die Segmentleitungskodes die Struktur und den Inhalt der Segmente repräsentieren und ebenfalls zur Fehlererkennung und -korrektur beitragen.

Durch die Übertragung aller erzeugten Segmentleitungskodes und Teilvorwärtsfehlerkorrekturleitungskodes kann der Empfänger die empfangenen Daten entsprechend analysieren und Fehler erkennen sowie korrigieren, um eine zuverlässige und genaue Übertragung der Nutzdaten im Fahrzeug zu gewährleisten.

Das beschriebene Verfahren bietet somit eine verbesserte Vorwärtsfehlerkorrektur, die insbesondere in anspruchsvollen Umgebungen wie Fahrzeugen, in denen Störungen und Signalverluste auftreten können, von großer Bedeutung ist. Es trägt zur Gewährleistung einer zuverlässigen und qualitativ hochwertigen Datenübertragung bei, was für verschiedene Anwendungen im Fahrzeugbereich von großer Bedeutung ist, wie beispielsweise autonomes Fahren, Fahrzeugsicherheitssysteme und Infotainment-Anwendungen.

Die Erfindung ermöglicht es stets zu jedem Zeitpunkt alle gewünschten Eigenschaften und Anforderungen an die serielle Kodierung bei effizientem Betrieb eines FECs beizubehalten. Durch die bewusste Positionierung des seriellen Kodierers nach den FEC-Einheiten ist das physikalische Verhalten auf dem Link stets deterministisch kontrollierbar (nicht der Fall bei Scrambler als serielle Kodierung).

Zudem wird durch die Wahl der FEC-Symbolgröße basierend auf der Datenwortgröße des jeweiligen seriellen Sub-Kodierers stets dafür gesorgt, dass Bitfehler immer minimal propagieren (ein defektes Leitungskode-Symbol erzeugt dann nur ein defektes FEC-Symbol).

Weiter wird durch die Verwendung von mehreren FEC-Sub-Kodierern eine sehr effiziente Art der sogenannten Verschachtelung (Interleaving) erzeugt. Dies ist ohne aufwändiges manuelles Verschachteln der Symbole möglich, was stets ein Vorhalten von Daten (mehr Latenz und Buffer) benötigen würde. Dies ermöglicht es auch Burstfehler z.B. 112/128 Bitfehler auf einmal zu korrigieren.

Nur durch den schematischen Aufbau in den Figuren 7A, 7B und 8A, 8B ist ersichtlich, dass dies der Fall ist: 128 Bitfehler führen in dem Falle zu jeweils nur einem einzigen Symbolfehler des jeweiligen FEC-Sub-Kodierers. Bei der klassischen Einzel-FEC-Kodierung würde ein gleich langer (128 fehlerhafte Bits in Folge) Burstfehler mehrere Symbolfehler hintereinander erzeugen. Dies kann je nach gewählter Kodierung dazu führen, dass das FEC-Wort (alle Symbole eines FEC-Zyklus) nicht mehr dekodiert werden können (damit ist dann auch eine Korrektur unmöglich). Normalerweise wird dies durch Verschachtelung (Interleaving) von Symbolen eines FEC-Zyklus mit denen eines oder mehrerer weiterer FEC-Zyklen erreicht. Dies ist allerdings nur unter Verwendung von Buffern sende- und empfangsseitig möglich um die Daten im Falle des Senders Verschachteln zu können und dieses im Empfänger wieder durch die inverse Operation in den ursprünglichen kontinuierlichen FEC-Symbol-Datenstrom der jeweils einzelnen FEC-Zyklen zu bringen. Durch die Verwendung mehrerer kleiner FEC-Kodierer wird die Verschachtelung und damit ebenfalls das Vorhalten von den für die Verschachtelung benötigten Buffern überflüssig (allerdings nur in gewissem Rahmen, ein Burstfehler von mehr als im Beispiel genannten 128 Bit in Folge führt dazu das pro individuellem FEC bereits mehr als ein Symbol beschädigt wird).

Wie viele Symbole ein jeweiliger FEC-Sub-Kodierer reparieren kann (t) ist abhängig von dem Overhead 2t siehe Abbildung 2. Dieser muss für die gewünschte Applikation entsprechend gewählt werden. Der in Figur 8A gezeigte Fall mit einem Symbolfehler pro FEC-Sub-Kodierer wird bereits bei t=1 (d.h. zwei Parity-Symbole Overhead) erreicht. Es ist ebenfalls anzumerken, dass der Burstfehler ebenfalls bedenkenlos ohne Einschränkungen im Bereich der Parity-Symbole passieren darf/ kann.

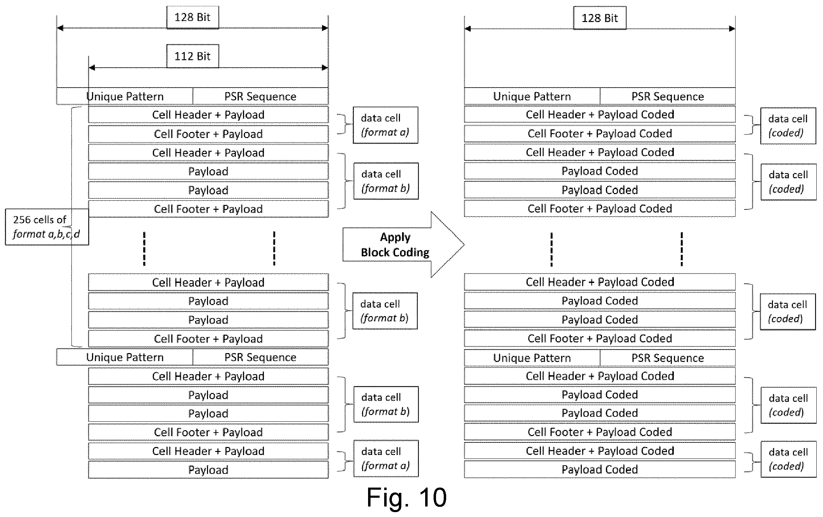

Figur 10 zeigt ein Datenformat, welches auf der linken Seite eine beliebige Bitfolge zeigt und auf der rechten Seite Teilsymbole. Die zu kodierenden Daten haben 112 Bit und die Teilsymbole haben 128 Bit. Auf diese Art und Weise wird eine beliebige Bitfolge von 112 Bit auf ein Gesamtsymbol von 128 Bit kodiert. Die kodierten 128 Bit sind bezüglich der Disparität optimiert. Der Pfeil in der Mitte deutet an, dass die Kodiereinheiten die Datensegmente auf der linken Seite in Teilsymbole auf der rechten Seite übersetzen. Auch ist in der vorliegenden Figur gezeigt, dass das Verfahren mehrfach angewendet werden kann, sodass auch mehrere beliebige Bitfolgen in mehrere beliebige Gesamtsymbole übersetzt werden kann. Darüber hinaus können die Daten in unterschiedliche Datenzellen bzw. Datenrahmen aufgeteilt sein.

Auch wenn die Daten auf der linken Seite semantisch den gleichen Inhalt haben wie die Daten auf der rechten Seite, so sind die Daten auf der rechten Seite derart kodiert, dass diese in ihrer Disparität optimiert sind. Generell ist das vorliegende Verfahren auf jegliche Daten anzuwenden, daher die beliebige Bitfolge, und es können sowohl Nutzdaten als auch Kopfdaten überführt werden.

Die eingetragenen Datenfelder sind lediglich beispielhaft zu verstehen und formen ein Anwendungsbeispiel der vorliegenden Erfindung.

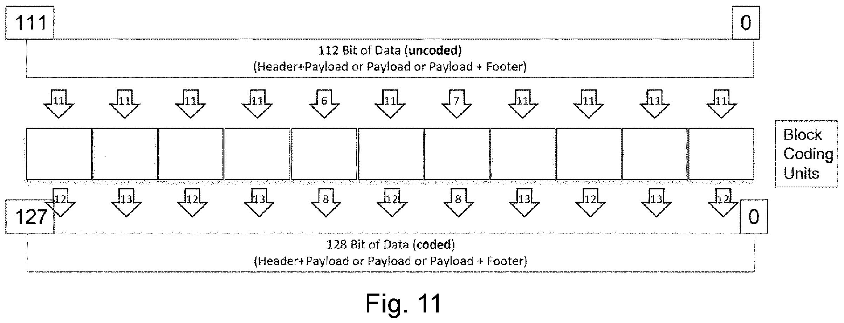

Figur 11 zeigt in der Mitte die Kodiereinheiten mitsamt den Eingängen und Ausgängen. Als Ausgangsdaten liegen 112 Bit vor, welche vorliegend den Index 0-111 aufweisen. Diese werden zerlegt in Segmente, welche 11,6, 7 oder andere Belegungen an Bitlängen aufweisen. Im vorliegenden Beispiel werden diese Segmente in Teilsymbole von 12,13, 8 oder andere Datenlängen übersetzt. Das vorgeschlagene Beispiel ist besonders vorteilhaft, da es 112 Bit in 128 Bit kodiert, wodurch ein besonders hohes Maß an Effizienz erreicht wird. So weisen die 128 Bit den gleichen Inhalt auf, wie die zu kodierende Bitfolge und ist lediglich um 16 Bit länger.

In der vorliegenden Figur ist links gezeigt, dass die beliebige Bitfolge von 112 Bit in unter anderem Datensegmente von 11 Bit segmentiert wird und sodann mittels der Kodiereinheit 11B12B in 12 Bit kodiert wird.

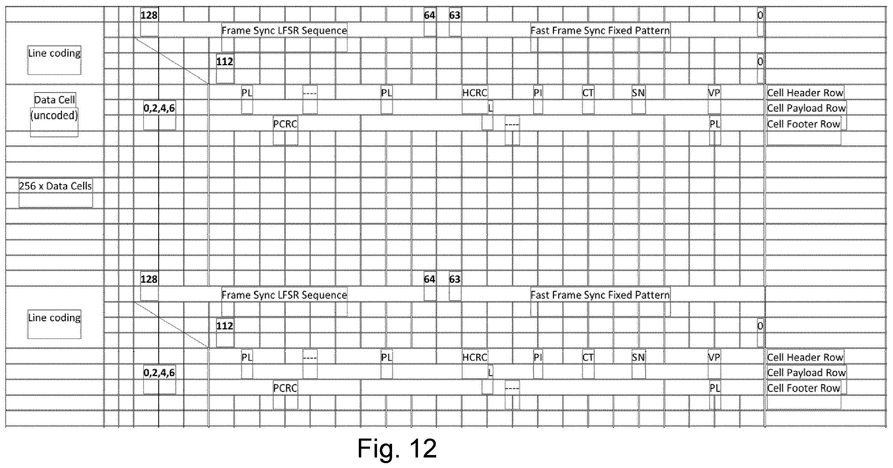

Figur 12 zeigt ein Datenformat, wie es beispielsweise in Figur 10 oder 11 Anwendung finden kann. Wiederum sind die 128 Bit Gesamtsymbol eingezeichnet sowie die beliebige Datenfolge von 112 Bit. Insgesamt können die beliebige Bitfolge und das Gesamtsymbol unterschiedliche Kopfdaten bzw. Rahmendaten aufweisen.

Im Folgenden werden einige konkrete Möglichkeiten geschaffen, wie Segmente der beliebigen Bitfolge in Teilsymbole übersetzt werden können, damit die Disparität minimiert bzw. eliminiert wird. Gezeigt wird in einer ersten Tabelle ein Überführen von 6 Bit nach 8 Bit, in einer zweiten Tabelle ein Überführen von 7 Bit nach 8 Bit, in einer dritten Tabelle ein Überführen von 11 Bit nach 12 Bit und in einer vierten Tabelle ein Überführen von 11 Bit nach 13 Bit. Es werden also Segmente von 6,7 oder 11 Bit in Teilsymbole von 8,12 oder 13 Bit überführt. Die gezeigten Kodierungen sind beispielhaft und verdeutlichen den technischen Effekt, der vorliegend erreicht wird. Die vorliegende Erfindung wurde empirisch evaluiert und erreicht anhand der vorgeschlagenen Kodierung, dass 112 Bit bezüglich ihrer Disparität derart optimiert werden können, dass lediglich 128 Bit erforderlich sind. Dies entspricht einem sogenannten Overhead von lediglich 14 %.

Vorliegend werden Zellen als Synonym für Rahmen beziehungsweise frames verwendet. Es kann sich hierbei auch um Pakete handeln.

### Zellformat/ Rahmenformat

Die Zelle besteht gemäß einem Aspekt der vorliegenden Erfindung aus einem Header mit fester Bitlänge, einem Payload-Bereich mit 4 wählbaren Bitlängen und einem Footer wiederum mit fester Bitlänge.

Die Zellstruktur ist eine Folge von Bits wie folgt:
- Eine virtuelle 7-Bit-Pfadkennung (VP), die eine eindeutige Adresse des virtuellen Pfads darstellt.
- Eine 3-Bit-Sequenznummer (SN), die die Zellen fortlaufend in ihrer Reihenfolge nummeriert.
- Eine 2 Bit breite Cell Type (CT)-Kennung, die die Länge der Nutzdaten angibt.
- Eine 3 Bit breite Payload Information (PI), die zusätzliche Informationen über die Nutzlast enthält. Dies kann auch zur Synchronisation von Nutzdaten und Rahmendaten oder Steuerdaten verwendet werden.
- Ein 10 Bit breites CRC-Polynom (HCRC) zum Fehlerschutz der Header-Informationen. Das Polynom hat bis zu einer Bitfolge von 21 Bit (P=0x2B9) eine Hamming-Distanz von 5.
- Der Payload (PL)-Bereich hat eine Länge von: 187, 411, 635 oder 859 Bit, abhängig vom CT-Wert. Die kürzeste Nutzlast wird so gewählt, dass sie immer noch größer ist als die größte unterstützte (Video-)Streaming-Busbreite. (Sollte die Abbildung von Stromdaten auf die Zellennutzlast vereinfachen).
- Abschließend ein 12 Bit breites CRC-Polynom (PCRC) zum Fehlerschutz der Nutzdaten. Das Polynom hat bis zu einer Bitfolge von 2035 Bit (P=0x8F3) eine Hamming-Distanz von 4.

### Format der Übertragungsrahmen

Der Übertragungsrahmen besteht gemäß einem Aspekt der vorliegenden Erfindung aus einer Folge von M-Bit breiten Wörtern. Der Rahmen beginnt mit einem M-Bit breiten "Komma"-Wort aus einer definierten Folge von Kommawörtern für die Rahmenausrichtung. Dann folgt K Zellen. Die Zellen bestehen aus 2, 4, 6 oder 8 N-Bit breiten Wörtern, die Header, Payload und Footer tragen. Diese N-Bit breiten Wörter werden zu M-Bit breiten Symbolen codiert (Zeilenkodierung).

Dieses Format wird gewählt, um die Verarbeitung von Zellendaten bei angemessenen Zeitfrequenzen zu ermöglichen, vorausgesetzt, dass der Serialisierer/ Deserialisierer immer einen Block von M Bits verarbeitet.

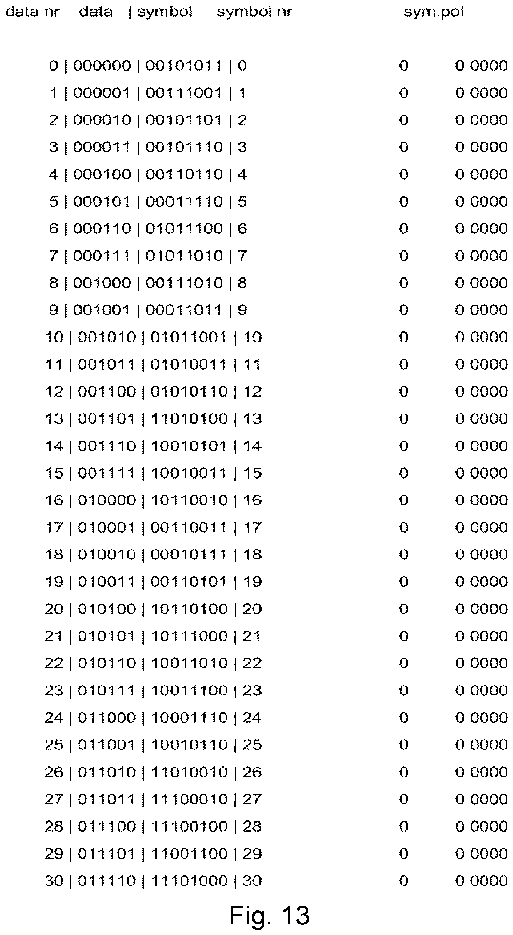

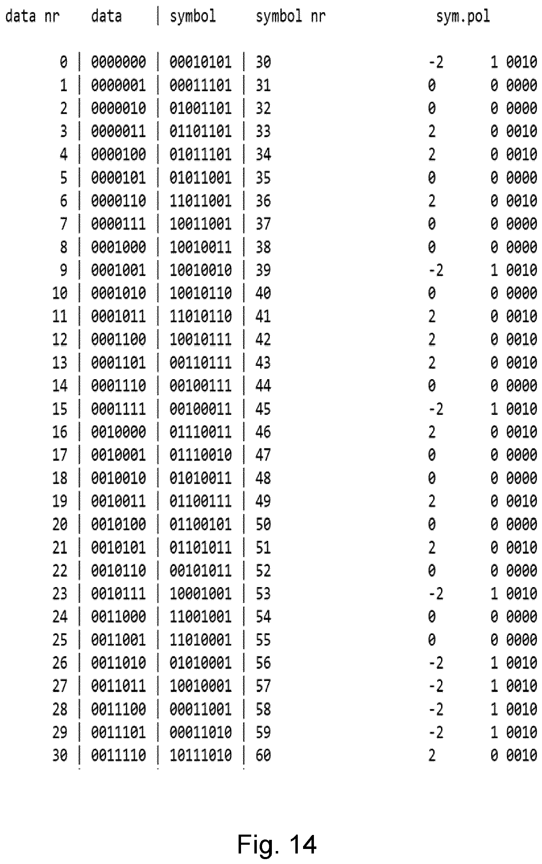

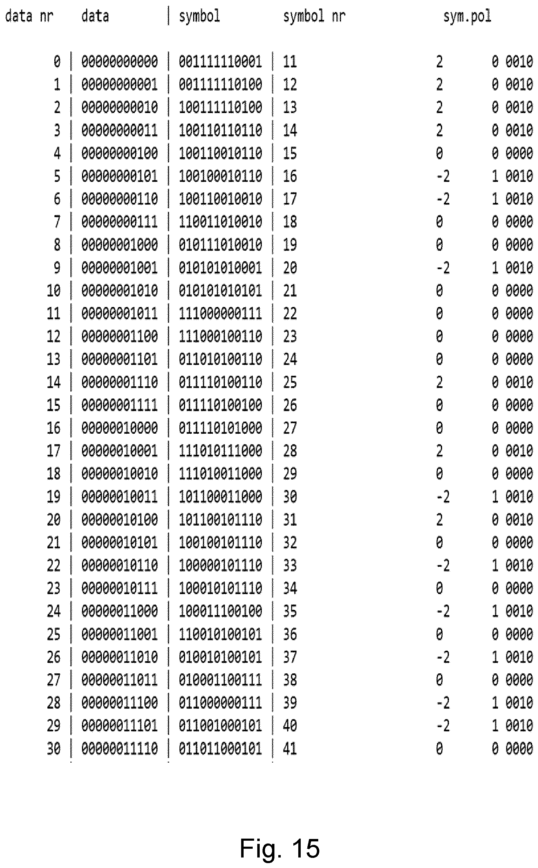

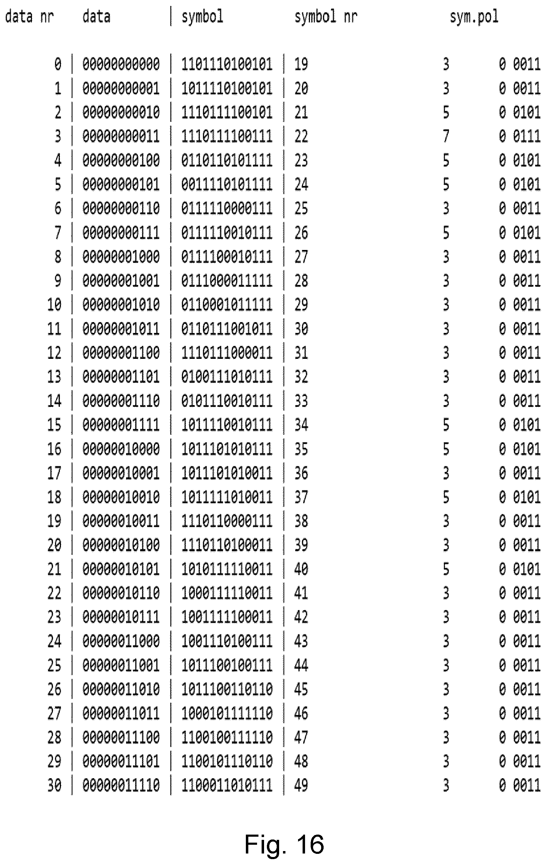

Figur 13 zeigt einen Ausschnitt einer beispielhaften Kodierung von Datensegmente auf Symbole, wobei 6 Bit auf 8 Bit derart kodiert werden, dass die Disparität gemäß einem Aspekt der vorliegenden Erfindung optimiert ist. Beispielsweise wird ein Segment 000000 auf ein Teilsymbol 00101011 kodiert, also ein 6B8B Kodierer. Weiterhin zeigt Figur 14 einen 7B8B Kodierer, Figur 15 einen 11B12B Kodierer und Figur 16 einen 11B13B Kodierer.

## Patentansprüche

1. Verfahren in einem Automobil zum Erzeugen einer effizient übertragbaren Bitfolge mit einer eingeschränkten Disparität, einer eingeschränkten Lauflänge und einer leitungskodierten Vorwärtsfehlerkorrektur, aufweisend:
- ein Bereitstellen (100) einer beliebigen Bitfolge;
- ein Segmentieren (101) der bereitgestellten Bitfolge in eine vorab definierte Folge von Segmenten gemäß einer jeweils vorab definierten Bitlänge;
- ein Berechnen (101A) einer Vorwärtsfehlerkorrektur für jedes der Segmente oder eine Vielzahl von Segmenten derselben Bitlänge;
- ein Kodieren (102) jedes Segments oder einer Vielzahl von Segmenten gleicher Bitposition mitsamt dessen/ deren Vorwärtsfehlerkorrektur in jeweils ein oder mehrere Teilsymbole, unter Verwendung jeweils derselben Kodiereinheit für die Segmente gleicher Bitposition und der zugehörigen Vorwärtsfehlerkorrektur aus einer Mehrzahl von Kodiereinheiten, wobei eine erste Teilmenge von Kodiereinheiten ein Vorzeichen der Disparität des Teilsymbols durch Invertieren der Disparität des erzeugten Teilsymbols zum Ausgleich einer Disparität einer zweiten Teilmenge von Kodiereinheiten aktiv steuert, wobei eine Aneinanderreihung der Teilsymbole die effizient übertragbare Bitfolge mitsamt den berechneten Vorwärtsfehlerkorrekturen ergibt.

2. Verfahren nach Anspruch 1, **dadurch gekennzeichnet, dass** das Berechnen (101A) einer Vorwärtsfehlerkorrektur für jedes der Segmente derart erfolgt, dass Segmente an gleicher Position aus mehreren segmentierten Bitfolgen zusammengefasst werden und hierüber die Vorwärtsfehlerkorrektur gebildet wird.

3. Verfahren nach Anspruch 1 oder 2, **dadurch gekennzeichnet, dass** die Disparität der zweiten Teilmenge von Kodiereinheiten nicht steuerbar ist.

4. Verfahren nach einem der vorhergehenden Ansprüche, **dadurch gekennzeichnet, dass** eine Gesamtheit der Teilvorwärtsfehlerkorrekturen die bereitgestellte Bitfolge korrigierbar beschreibt.

5. Verfahren nach einem der vorhergehenden Ansprüche, **dadurch gekennzeichnet, dass** die Kodiereinheiten bezüglich der vorabdefinierten Bitlängen eine minimale Anzahl an Gattern aufweisen.

6. Verfahren nach einem der vorhergehenden Ansprüche, **dadurch gekennzeichnet, dass** jeder Kodiereinheit eine Berechnungseinheit zum Berechnen der Vorwärtsfehlerkorrektur vorgeschaltet wird.

7. Verfahren nach einem der vorhergehenden Ansprüche, **dadurch gekennzeichnet, dass** Kodiereinheiten der ersten Teilmenge Segmente von 11 Bit auf Teilsymbole von 13 Bit kodieren.

8. Verfahren nach einem der vorhergehenden Ansprüche, **dadurch gekennzeichnet, dass** Kodiereinheiten der ersten Teilmenge eine Disparität zwischen +3 und +9 aufweisen, welche durch bitweises Invertieren des Teilsymbols gezielt auf -3 bis -9 invertiert werden.

9. Verfahren nach einem der vorhergehenden Ansprüche, **dadurch gekennzeichnet, dass** die Lauflänge in Teilsymbolen maximal 7 beträgt.

10. Verfahren nach einem der vorhergehenden Ansprüche, **dadurch gekennzeichnet, dass** die Lauflänge des Teilsymbols bei Kodiereinheiten der ersten Teilmenge ausgehend vom höchstwertigsten und/ oder vom niederwertigsten Bit maximal 5 beträgt.

11. Verfahren nach einem der vorhergehenden Ansprüche, **dadurch gekennzeichnet, dass** bei Kodiereinheiten der zweiten Teilmenge 11 Bit- Segmente auf 12 Bit- Teilsymbole oder 7 Bit- Segmente auf 8 Bit- Teilsymbole oder 6 Bit- Segmente auf 8 Bit- Teilsymbole kodiert werden.

12. Verfahren nach einem der vorhergehenden Ansprüche, **dadurch gekennzeichnet, dass** ein Multiplexer bei einem Anliegen eines bezüglich der Disparität positiven Datenstroms und eines negativen Datenstroms denjenigen Datenstrom auswählt, der zur Minimierung der Gesamtdisparität des Gesamtsymbols beiträgt.

13. Systemanordnung in einem Automobil zur Erzeugung einer effizient übertragbaren Bitfolge mit einer eingeschränkten Disparität und einer eingeschränkten Lauflänge, aufweisend:
- eine Schnittstelleneinheit eingerichtet zum Bereitstellen (100) einer beliebigen Bitfolge;
- eine Segmentierungseinheit eingerichtet zum Segmentieren (101) der bereitgestellten Bitfolge in eine vorab definierte Folge von Segmenten gemäß einer jeweils vorab definierten Bitlänge;
- eine Berechnungseinheit eingerichtet zum Berechnen (101A) einer Vorwärtsfehlerkorrektur für jedes der Segmente oder eine Vielzahl von Segmenten derselben Bitlänge;
- eine Kodieranordnung eingerichtet zum Kodieren (102) jedes Segments oder einer Vielzahl von Segmenten gleicher Bitposition mitsamt dessen/ deren Vorwärtsfehlerkorrektur in jeweils ein oder mehrere Teilsymbole, unter Verwendung jeweils derselben Kodiereinheit für die Segmente gleicher Bitposition und der zugehörigen Vorwärtsfehlerkorrektur aus einer Mehrzahl von Kodiereinheiten, wobei eine erste Teilmenge von Kodiereinheiten ein Vorzeichen der Disparität des Teilsymbols durch Invertieren der Disparität des erzeugten Teilsymbols zum Ausgleich einer Disparität einer zweiten Teilmenge von Kodiereinheiten aktiv steuert, wobei eine Aneinanderreihung der Teilsymbole die effizient übertragbare Bitfolge mitsamt den berechneten Vorwärtsfehlerkorrekturen ergibt.

14. Computerprogrammprodukt, umfassend Befehle, die bei der Ausführung des Programms durch mindestens einen Computer diesen veranlassen, die Schritte des Verfahrens nach einem der Ansprüche 1 bis 12 auszuführen.

15. Computerlesbares Speichermedium, umfassend Befehle, die bei der Ausführung durch mindestens einen Computer diesen veranlassen, die Schritte des Verfahrens nach einem der Ansprüche 1 bis 13 auszuführen.
